# EUROPEAN PATENT APPLICATION

(11) **EP 4 394 749 A1**
(43) Date of publication of application: **03.07.2024**
(21) Application number: 22881190.7
(22) Date of filing: 22.08.2022
(51) Int. Cl.: G09G 3/20, H10K 59/00, H10K 50/80, G06F 3/041

(54) **DISPLAY DEVICE FOR CONTROLLING VIEWING ANGLE AND ELECTRONIC DEVICE**

(30) Priority: 13.10.2021 KR 20210136186; 29.10.2021 KR 20210147402
(71) Applicant: Samsung Electronics Co., Ltd., Suwon-si, Gyeonggi-do 16677 (KR)
(72) Inventor: SHIN, Sungyoung, Suwon-si Gyeonggi-do 16677 (KR); UHM, Minsuk, Suwon-si Gyeonggi-do 16677 (KR); WU, Yilin, Suwon-si Gyeonggi-do 16677 (KR); LEE, Dongseop, Suwon-si Gyeonggi-do 16677 (KR); LEE, Haechang, Suwon-si Gyeonggi-do 16677 (KR); KIM, Kwangtai, Suwon-si Gyeonggi-do 16677 (KR); YEOM, Donghyun, Suwon-si Gyeonggi-do 16677 (KR)
(74) Representative: HGF
(86) International application number: PCT/KR2022/012489
(87) International publication number: WO 2023/063560

(57) **Abstract**

A display device comprises a display panel and a display driving circuit operatively coupled to the display panel. The display panel may include: a pixel layer including a first set of a plurality of first pixels and a second set of a plurality of second pixels providing a viewing angle that is narrower than a viewing angle provided through the plurality of first pixels; a conductive pattern disposed on the pixel layer; and an organic insulating layer disposed between a transparent member and the conductive pattern, and including a light blocking member in contact with the transparent member and having openings dividing each of sub-pixels included in each of the plurality of second pixels. Various other embodiments are possible.

## Description

### [Technical Field]

The following descriptions relate to a display device for controlling a viewing angle and an electronic device.

### [Background Art]

A portable electronic device may transfer visual information to an outside through a display. The display may transfer visual information as a combination of lights transferred by pixels. The portable electronic device is used in various environments. For example, in case that several people are watching content together, a wide viewing angle may be required, and in case that they are viewing private information they do not want to be exposed to others, a narrow viewing angle may be required. According to an angle of light transferred by the pixels, the viewing angle of light transferred through the display may be determined.

### [Disclosure]

### [Technical Problem]

A usage environment of a portable electronic device such as a smartphone may vary. The portable electronic device is also used in a private space such as home, but since a user always carry or use the portable electronic device, it may be used in public places such as public transportation, lounge, or coffee shop. In case of using the portable electronic device in the public place, a person other than the user may be able to check a content of the portable device of the user. There is a need for a way to prevent unwanted information from being transferred to others.

A display device and an electronic device capable of adjusting a viewing angle of a display according to a change in the environment of the user may provide a way for adjusting the viewing angle.

Technical tasks to be achieved in the present disclosure are not limited to the technical tasks mentioned above, and other technical tasks not mentioned will be clearly understood by those having ordinary knowledge in the art to which the present disclosure belongs from the description below.

### [Technical Solution]

A display device may comprise a display panel and a display driving integrated circuitry (DDI) operatively coupled with the display panel, wherein the display panel may include a transparent member, a pixel layer including a first set of a plurality of first pixels and a second set of a plurality of second pixels providing a viewing angle narrower than a viewing angle provided through the plurality of first pixels, a conductive pattern disposed on the pixel layer, and an organic insulation layer disposed between the transparent member and the conductive pattern, in contact with the transparent member, and including a light blocking member having openings dividing each of sub pixels included in each of the plurality of second pixels, wherein the DDI may be configured to provide a first mode of displaying an image based on driving both the first set and the second set and to provide a second mode of displaying an image based on driving all of the second pixels in the second set and some of a plurality of sub pixels in each of the first pixels in the first set or displaying the image based on driving the second set of the first set and the second set.

An electronic device may comprise a transparent member, a pixel layer including a first set of a plurality of first pixels and a second set of a plurality of second pixels providing a viewing angle narrower than a viewing angle provided through the plurality of first pixels, switches driving each of the first pixels and the second pixels and disposed below the pixel layer, a conductive pattern disposed on the pixel layer, a protection layer disposed between the conductive pattern and an organic insulation layer and surrounding the conductive pattern, the organic insulation layer disposed between the transparent member and the conductive pattern, in contact with the transparent member, and including a light blocking member having openings dividing each of sub pixels included in each of the plurality of second pixels, and a display driving integrated circuitry (DDI) operatively coupled with the switches, wherein the DDI is configured to provide a first mode of displaying an image based on driving both the first set and the second set and to provide a second mode of displaying an image based on driving all of the second pixels in the second set and some of a plurality of sub pixels in each of the first pixels in the first set or displaying the image based on driving the second set of the first set and the second set.

A display device according to an embodiment may comprise a display panel and a display driving integrated circuitry (DDI) operatively coupled with the display panel, wherein the display panel may include a transparent member, a pixel layer including a first set of a plurality of first pixels and a second set of a plurality of second pixels providing a viewing angle narrower than a viewing angle provided through the plurality of first pixels, a touch electrode including a conductive pattern disposed on one layer disposed between the transparent member and the pixel layer, an organic insulation layer in contact with the transparent member and one surface of the conductive pattern facing the transparent member, and including a light blocking member having openings dividing each of sub pixels included in each of the plurality of first pixels and the plurality of second pixels and surrounding the conductive pattern exposed toward the transparent member, wherein the DDI is configured to provide a first mode of displaying an image based on driving both the first set and the second set and to provide a second mode of displaying an image based on driving all of the second pixels in the second set and some of a plurality of sub pixels in each of the first pixels in the first set or displaying the image based on driving the second set of the first set and the second set.

### [Advantageous Effects]

A display device and an electronic device for controlling a viewing angle according to an embodiment may provide visual information with a wide viewing angle in a normal mode and provide visual information with a narrow viewing angle in a private mode.

The display device and electronic device for controlling the viewing angle may secure stable performance of a touch electrode by solving a lack of distance between the touch electrode and an electrode of a display panel due to removal of a polarizer.

The display device and electronic device for controlling the viewing angle may simplify a process by replacing a protection layer of a touch screen panel with another protection member. The simplification of the process may reduce overall manufacturing time.

Effects obtainable in the present disclosure are not limited to the effects mentioned above, and other effects not mentioned will be clearly understood by those having ordinary knowledge in the art to which the present disclosure belongs from the description below.

### [Description of the Drawings]

FIG. 1 is a block diagram of an electronic device in a network environment according to an embodiment.
FIG. 2 is a block diagram of a display module, according to an embodiment.
FIG. 3 illustrates an example of some pixels of a display device according to an embodiment.
FIG. 4 illustrates a positional relationship between a pixel and a light blocking member inside a display device, according to an embodiment.
FIG. 5 illustrates a change in a characteristic of a touch electrode according to a change in a distance between the touch electrode and a pixel electrode of a display device according to an embodiment.
FIG. 6A illustrates a disposition of a first pixel of a display device according to an embodiment.
FIG. 6B illustrates a disposition of a second pixel of a display device according to an embodiment.
FIG. 6C illustrates a disposition in which a light blocking member of a color filter layer and a part of a pixel define portion are omitted in a portion corresponding to a second pixel of a display device according to an embodiment.
FIG. 7A is an example illustrating a configuration in which a protection layer of a touch electrode is included in a light blocking member in a portion where a first pixel of a display device is disposed according to an embodiment.
FIG. 7B is an example illustrating a configuration in which a protection layer of a touch electrode is included in a light blocking member in a portion where a second pixel of a display device is disposed according to an embodiment.
FIG. 7C illustrates a disposition in which a light blocking member of a color filter layer and a part of a pixel define portion are omitted while a protection layer of a touch electrode is included in the light blocking member in a portion corresponding to a second pixel of a display device according to an embodiment.
FIG. 8A illustrates an example of a sub pixel of a first pixel and a sub pixel of a second pixel of a display device according to an embodiment.
FIG. 8B illustrates a disposition of a first pixel of a display device according to another embodiment.
FIG. 8C illustrates a disposition of a second pixel of a display device according to another embodiment.
FIG. 8D illustrates a disposition in which a light blocking member of a color filter layer and a part of a pixel define portion are omitted in a portion corresponding to a second pixel of a display device according to another embodiment.
FIG. 9A is an example illustrating a configuration in which a protection layer of a touch electrode is included in a light blocking member in a portion in which a first pixel of a display device is disposed according to another embodiment.
FIG. 9B is an example illustrating a configuration in which a protection layer of a touch electrode is included in a light blocking member in a portion in which a second pixel of a display device is disposed according to another embodiment.
FIG. 9C illustrates a disposition in which a light blocking member of a color filter layer and a part of a pixel define portion are omitted while a protection layer of a touch electrode is included in the light blocking member in a portion corresponding to a second pixel of a display device according to another embodiment.

### [Mode for Invention]

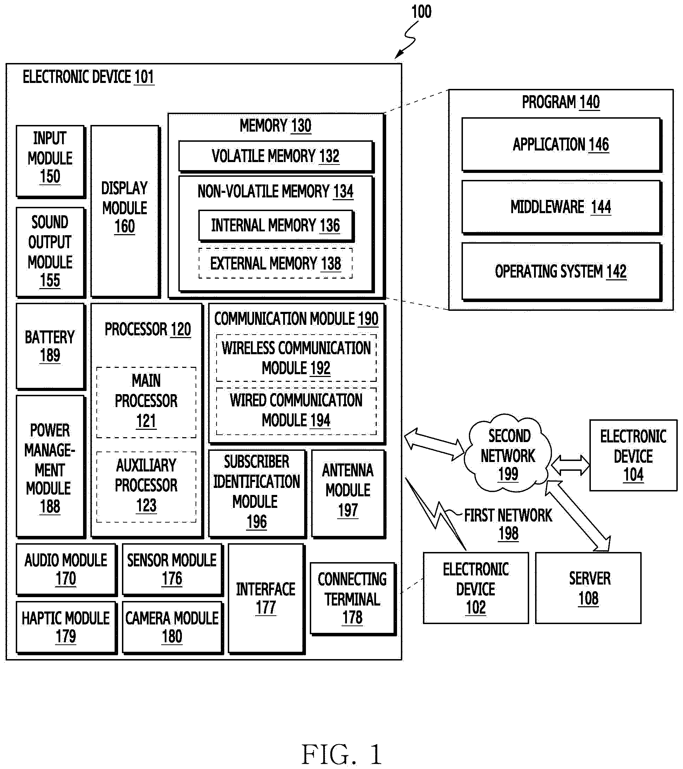

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

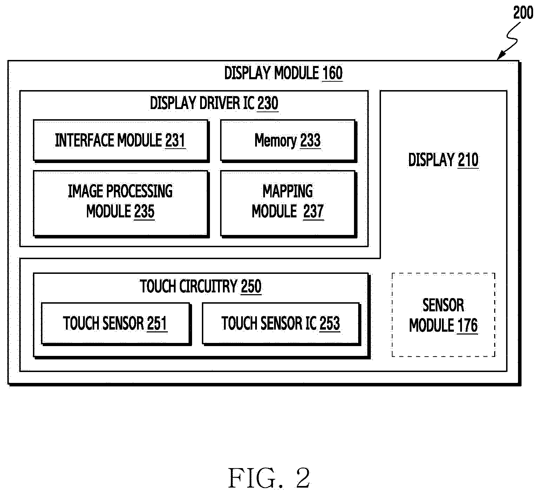

Fig. 2 is a block diagram 200 illustrating the display module 160 according to various embodiments. Referring to Fig. 2, the display module 160 may include a display 210 and a display driver integrated circuit (DDI) 230 to control the display 210. The DDI 230 may include an interface module 231, memory 233 (e.g., buffer memory), an image processing module 235, or a mapping module 237. The DDI 230 may receive image information that contains image data or an image control signal corresponding to a command to control the image data from another component of the electronic device 101 via the interface module 231. For example, according to an embodiment, the image information may be received from the processor 120 (e.g., the main processor 121 (e.g., an application processor)) or the auxiliary processor 123 (e.g., a graphics processing unit) operated independently from the function of the main processor 121. The DDI 230 may communicate, for example, with touch circuitry 150 or the sensor module 176 via the interface module 231. The DDI 230 may also store at least part of the received image information in the memory 233, for example, on a frame by frame basis. The image processing module 235 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 210. The mapping module 237 may generate a voltage value or a current value corresponding to the image data preprocessed or post-processed by the image processing module 235. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 210 may be driven, for example, based at least in part on the voltage value or the current value such that visual information (e.g., a text, an image, or an icon) corresponding to the image data may be displayed via the display 210.

According to an embodiment, the display module 160 may further include the touch circuitry 250. The touch circuitry 250 may include a touch sensor 251 and a touch sensor IC 253 to control the touch sensor 251. The touch sensor IC 253 may control the touch sensor 251 to sense a touch input or a hovering input with respect to a certain position on the display 210. To achieve this, for example, the touch sensor 251 may detect (e.g., measure) a change in a signal (e.g., a voltage, a quantity of light, a resistance, or a quantity of one or more electric charges) corresponding to the certain position on the display 210. The touch circuitry 250 may provide input information (e.g., a position, an area, a pressure, or a time) indicative of the touch input or the hovering input detected via the touch sensor 251 to the processor 120. According to an embodiment, at least part (e.g., the touch sensor IC 253) of the touch circuitry 250 may be formed as part of the display 210 or the DDI 230, or as part of another component (e.g., the auxiliary processor 123) disposed outside the display module 160.

According to an embodiment, the display module 160 may further include at least one sensor (e.g., a fingerprint sensor, an iris sensor, a pressure sensor, or an illuminance sensor) of the sensor module 176 or a control circuit for the at least one sensor. In such a case, the at least one sensor or the control circuit for the at least one sensor may be embedded in one portion of a component (e.g., the display 210, the DDI 230, or the touch circuitry 150)) of the display module 160. For example, when the sensor module 176 embedded in the display module 160 includes a biometric sensor (e.g., a fingerprint sensor), the biometric sensor may obtain biometric information (e.g., a fingerprint image) corresponding to a touch input received via a portion of the display 210. As another example, when the sensor module 176 embedded in the display module 160 includes a pressure sensor, the pressure sensor may obtain pressure information corresponding to a touch input received via a partial or whole area of the display 210. According to an embodiment, the touch sensor 251 or the sensor module 176 may be disposed between pixels in a pixel layer of the display 210, or over or under the pixel layer.

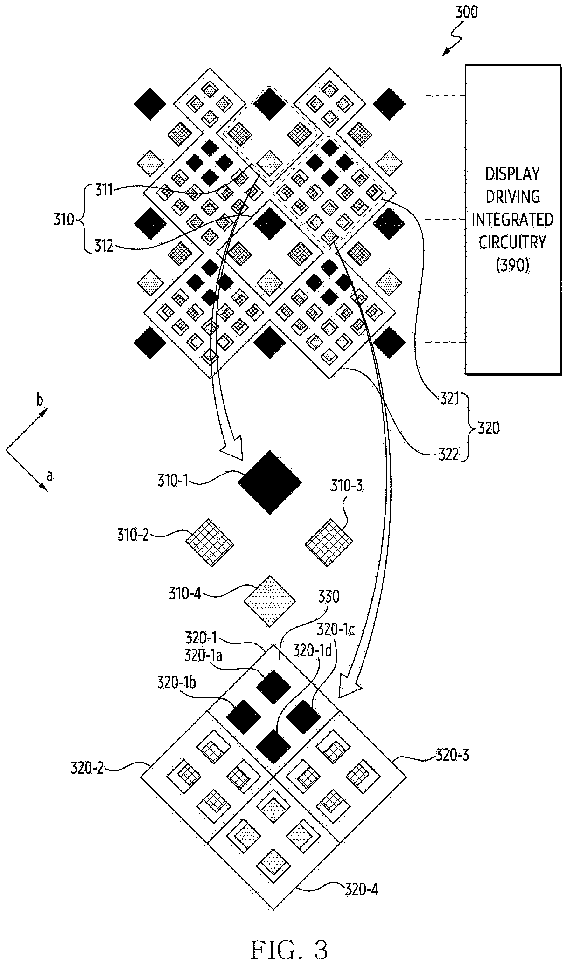

FIG. 3 illustrates an example of some pixels of a display device according to an embodiment.

Referring to FIG. 3, a display device 300 (e.g., the display module 160 of FIG. 1) may include a display panel including a first set 310 of first pixels 311 and 312 and a second set 320 of second pixels 321 and 322 and a display driving integrated circuitry 390 (e.g., the display driver IC 230 of FIG. 2). The display device 300 may be referred to as the display module 160.

According to an embodiment, the display device 300 may have a set of pixels that provide a different viewing angle. For example, the display device 300 may include the first pixels 311 and 312 and the second pixels 321 and 322 having a viewing angle narrower than a viewing angle of the first pixels 311 and 312.

According to an embodiment, the display device 300 may provide the different viewing angle by driving the first pixels 311 and 312, the second pixels 321 and 322, or pixels according to a combination of each of the first pixels 311 and 312 and each of the second pixels 321 and 322 according to an environment a user is in.

According to an embodiment, the display device 300 may operate in a first mode that provides a wide viewing angle to the user. For example, the display driving integrated circuitry 390 may provide the wide viewing angle to the user by driving both the first set 310 including the first pixels 311 and 312 and the second set 320 including the second pixels 321 and 322.

According to an embodiment, the display device 300 may operate in a second mode that provides a viewing angle narrower than the first mode to the user. The display driving integrated circuitry 390 may provide a narrow viewing angle to the user by driving the second set 320 including the second pixels 321 and 322. According to an embodiment, the display driving integrated circuitry 390 may increase contrast ratio while providing the narrow viewing angle to the user by driving all of the second pixels 321 and 322 of the second set 320 and some of the first pixels 311 and 312 of the first set 310 in order to clarify the contrast of light and dark or luminance and increase the contrast ratio compared to driving only the second set 320.

According to an embodiment, the first pixels 311 and 312 may be alternately disposed with the second pixels 321 and 322. The first pixels 311 and 312 may be disposed along a first direction a, and each of the first pixels 311 and 312 may be spaced apart from each other. The first pixels 311 and 312 may be disposed along a second direction b, and each of the first pixels 311 and 312 may be spaced apart from each other. The second pixels 321 and 322 may be disposed between the first pixels 311 and 312. The second pixels 321 and 322 may be disposed along the first direction a, and each of the second pixels 321 and 322 may be spaced apart from each other. The second pixels 321 and 322 may be disposed along the second direction b, and each of the second pixels 321 and 322 may be spaced apart from each other. Although the first pixels 311 and 312 and the second pixels 321 and 322 have been described as being alternately disposed, it is not limited thereto. For another example, the first pixels 311 and 312 and the second pixels 321 and 322 may be disposed along the first direction a, columns formed by the first pixels 311 and 312 may be spaced apart along the second direction b, and each of columns formed by the second pixels 321 and 322 may be disposed between the columns formed by the first pixels 311 and 312.

One pixel composing the first set 310 of the first pixels 311 and 312 may include a plurality of sub pixels 310-1, 310-2, 310-3, and 310-4. Each of the plurality of sub pixels 310-1, 3 10-2, 3 10-3, and 310-4 may provide a designated color. For example, the first sub pixel 310-1 of the first pixel 311 may provide red light, the second sub pixel 310-2 and the third sub pixel 310-3 of the first pixel 311 may provide green light, and the fourth sub pixel 310-4 of the first pixel 311 may provide blue light. One vertex of the first sub pixel 310-1 and one vertex of the fourth sub pixel 310-4 may face each other and the second sub pixel 310-2 or the third sub pixel 310-3 may be disposed in each of spaces between the first sub pixel 310-1 and the fourth sub pixel 310-4. For example, the second sub pixel 310-2 may be disposed between one edge of the first sub pixel 310-1 and one edge of the fourth sub pixel 310-4 perpendicular to the first sub pixel 310-1. The plurality of sub pixels 310-1, 310-2, 310-3, and 310-4 may be distinguished by a pixel define layer or a light blocking member formed inside the display device 300. A plurality of first pixels 311 and 312 may have a sub pixel disposition structure that is substantially the same as the above-described structure.

According to an embodiment, one pixel composing the second set 320 of the second pixels 321 and 322 may include a plurality of sub pixels 320-1, 320-2, 320-3, and 320-4. Each of the plurality of sub pixels 320-1, 320-2, 320-3, and 320-4 may provide a designated color. For example, the first sub pixel 320-1 of the second pixel 321 may provide red light, the second sub pixel 320-2 and the third sub pixel 320-3 of the second pixel 321 may provide green light, and the fourth sub pixel 320-4 of the second pixel 321 may provide blue light. The first sub pixel 320-1, the second sub pixel 320-2, the fourth sub pixel 320-4, and the third sub pixel 320-3 of the second pixel 312 may be sequentially disposed in a counterclockwise direction. The plurality of sub pixels 320-1, 320-2, 320-3, and 320-4 of the second pixel 321 may be distinguished by the pixel define layer or a light blocking member 330 formed inside the display device 300.

According to an embodiment, the light blocking member 330 may include openings that divide each of the plurality of sub pixels 320-1, 320-2, 320-3, and 320-4 of the second pixel 321. For example, the first sub pixel 320-1 of the second pixel 321 may be divided into four by the light blocking member 330. The first sub pixel 320-1 may be divided into a first micropixel 320-1a, a second micropixel 320-1b, a third micropixel 320-1c, and a fourth micropixel 320-1d by the light blocking member 330. The light blocking member 330 may include four openings in a portion corresponding to the first sub pixel 320-1 of the second pixel 321 and may divide the first sub pixel 320-1 of the second pixel 321 into the first micropixel 320-1a, the second micropixel 320-1b, the third micropixel 320-1c, and the fourth micropixel 320-1d through the four openings. A viewing angle provided by the first sub pixel 320-1 may be determined by a distance between the openings composing the light blocking member 330 or size of the openings.

The display device 300 according to the above-described embodiment may drive all pixels or some designated pixels according to an input or a change in the environment by including the first set 310 of the plurality of first pixels 311 and 312 providing a wide viewing angle and the second set 320 of the second pixels 321 and 322 providing a viewing angle narrower than a viewing angle provided through the first pixels 311 and 312. The change in the environment may be whether the user is within range of a designated position. Taking pixel driving according to the change in the environment as an example, a processor (e.g., the processor 120 of FIG. 1) may provide the first mode that drives all pixels in the first set 310 and the second set 320 in a case that an electronic device (e.g., the electronic device 101 of FIG. 1) including the display device 300 is placed in a first place (e.g., home or accommodation) designated by the user or within a range that includes the first place. In a case that the electronic device 101 leaves the first place or the range including the first place, the processor 120 may drive all pixels in the second set 320, or drive all pixels in the second set 320 and some pixels in the first set 310, and provide the second mode that provides the viewing angle narrower than the viewing angle provided in the first mode. According to the change in the environment, the electronic device 101 may transfer visual information having a different viewing angle to the user. For another example, it may be changed to the first mode or the second mode through a user's touch or a key button input, so that the viewing angle may be adjusted according to the user's needs.

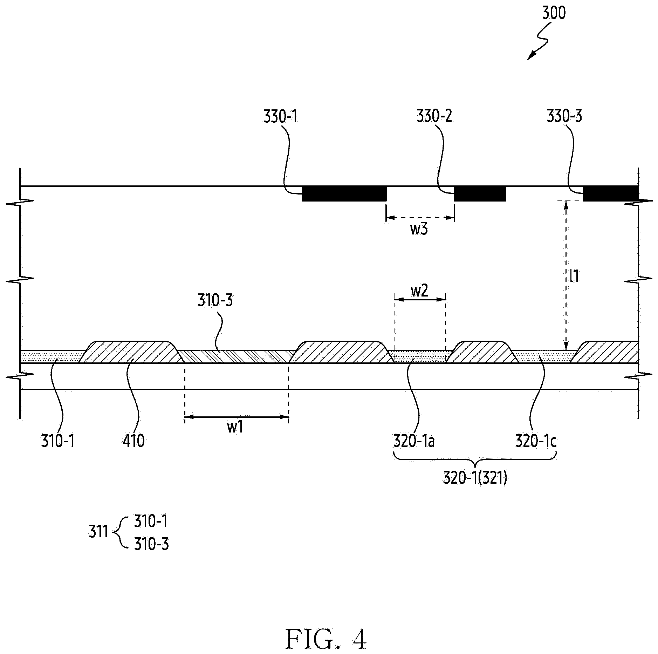

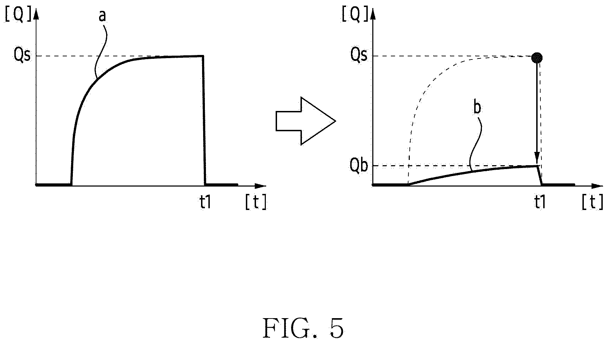

FIG. 4 illustrates a positional relationship between a pixel and a light blocking member inside a display device, according to an embodiment, and FIG. 5 illustrates a change in a characteristic of a touch electrode according to a change in a distance between the touch electrode and a pixel electrode of the display device, according to an embodiment.

Referring to FIG. 4, a display device 300 may include sub pixels 310-1 and 310-3 of a first pixel 311 and sub pixels 320-1 of a second pixel 321. Each of the sub pixels 310-1, 310-3, and 320-1 may include an organic lighting emitting diode (OLED) having an organic light emitting material capable of emitting light in a designated color. The sub pixel 320-1 of the second pixel 321 may be disposed to be spaced apart from the first pixel 311 including the first sub pixel 310-1 and the third sub pixel 310-3.

According to an embodiment, a pixel define layer (PDL) 410 may distinguish the first pixel 311 and the second pixel 321, and may classify sub pixels of each of the first pixel 311 and the second pixel 321. The pixel define layer 410 may classify each sub pixel of an organic light emitting layer so that they do not interfere with each other. The pixel define layer 410 may distinguish micropixels 320-1a and 320-1c included in the first sub pixel 320-1 of the second pixel 321. For example, the pixel define layer 410 may be disposed between main pixels such as the first pixel 311 and the second pixel 321 of a pixel layer. The pixel define layer 410 may be disposed between the sub pixels 310-1, 310-3, and 320-1 of the first pixel 311 and the second pixel 321. According to an embodiment, the pixel define layer 410 may be disposed between the micropixels 320-1a and 320-1c in order to classify the second pixel 321 having a narrow viewing angle into micropixels 320-1a and 320-1c.

According to an embodiment, a width w1 of the sub pixels 310-1 and 310-3 of the first pixel 311 having a first viewing angle may be wider than a width w2 of the micropixels 320-1a and 320-1c composing the sub pixel 320-1 of the second pixel 321 having a second viewing angle narrower than the first viewing angle.

According to an embodiment, the viewing angle provided by the micropixels 320-1a and 320-1c composing the sub pixel 320-1 of the second pixel 321 may be determined by a distance to light blocking members 330-1, 330-2, and 330-3 spaced apart from the pixel. When the distance between the light blocking members 330-1, 330-2, and 330-3 and the second pixel 320-1 is short, the viewing angle becomes wide, and thus a distance to compensate for this is required. In order to compensate for the viewing angle, a distance 11 from a pixel layer including the pixels 310-1, 310-2, and 320-1 of the display device 300 to a surface formed by the light blocking members 330-1, 330-2, and 330-3 may be set based on the width w2 of the micropixels 320-1a and 320-1c.

According to an embodiment, when a distance between the light blocking members 330-1, 330-2, and 330-3 is equal to the width w2 of the micropixels 320-1a and 320-1c, the distance 11 between the light blocking member and the pixel may be greater than the width w2 of the micropixel in order to reduce the viewing angle.

According to an embodiment, a width w3 between the light blocking members 330-1 and 330-2 disposed on the second pixel 321 of the display device 300 may be determined according to the viewing angle of the second pixel 321. For example, as the width w3 between the light blocking members 330-1, 330-2, and 330-3 disposed on the micropixels 320-1a and 320-1c becomes narrower, the viewing angle may become narrower. For example, as the width w3 of the light blocking members 330-1 and 330-2 becomes narrower than the width w2 of the micropixel 320-1a, the display device 300 may have a narrow viewing angle.

Referring to FIG. 5, a graph a represents a reference charge amount Qs and saturation time t1, and a graph b represents a charge amount and charging time in case that a distance from the touch electrode to the electrode of the display panel becomes closer. The reference charge amount Qs may vary according to the distance between the touch electrode and the electrode of the display panel. For example, in case that capacitance increases due to proximity between two conductors, a value of the reference charge amount to be buffered may increase, and in case that the capacitance decreases due to the two conductors are far apart, the value of the reference charge amount to be buffered may decrease. The time required for response speed of the touch electrode may have a designated value.

Referring to the graph a, the time t1 in which charge amount is saturated up to the reference charge amount Qs may be required when an external object contacts the conductive pattern. Referring to the graph b, as a distance between the conductive pattern of the touch electrode and the electrode of the display panel becomes closer, the value of capacitance may increase. When the value of capacitance increases, the value of the reference charge amount Qs to be saturated may increase. Due to an increase of saturation charge amount, the charging time may increase and a delay in reaction time of the touch electrode may occur. Due to the increase in the charging time, a time at which a sufficient charge amount is secured may be delayed later than a reference time t1. For example, since the charging charge amount Qb may not reach the reference charge amount Qs in the reference time t1 due to the increased capacitance, a delay may occur and the response speed of the touch electrode may decrease.

According to the above-described description of the graph, in order to reduce the delay in the response speed of the touch electrode, the distance between the touch electrode and the display panel may be greater than or equal to the designated distance.

According to an embodiment, in order for the display device 300 to provide a narrow viewing angle, the display device 300 may provide a structure that secures a distance between the pixel and the light blocking member and a structure that secures a gap between the conductive pattern and the electrode of the display panel. Contents to be described later will describe a structure that secures the distance between the above-mentioned pixel and the light blocking member and the structure that secures the distance between the conductive pattern and the electrode of the display panel.

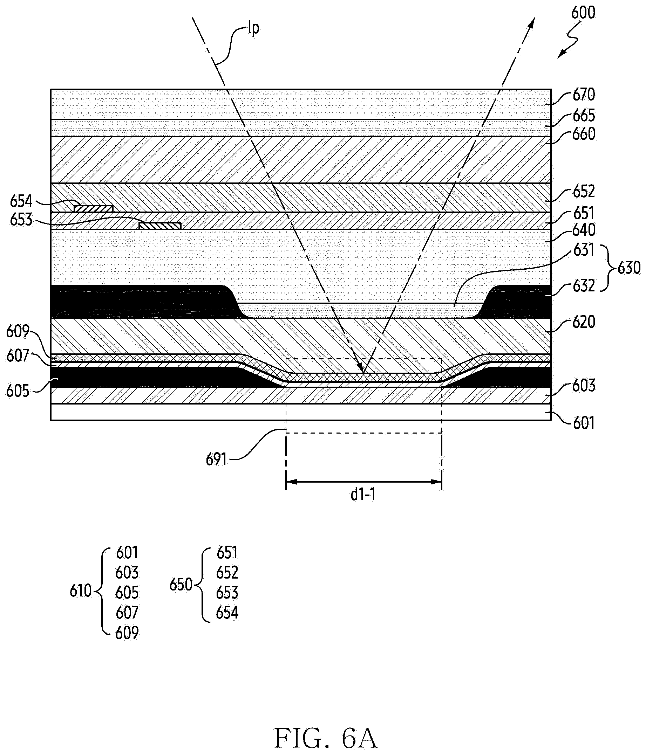

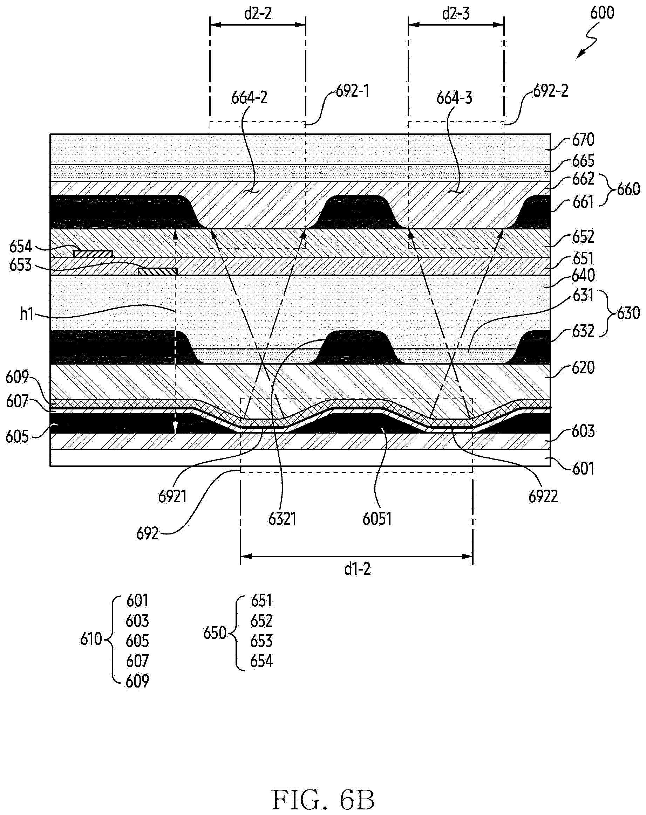

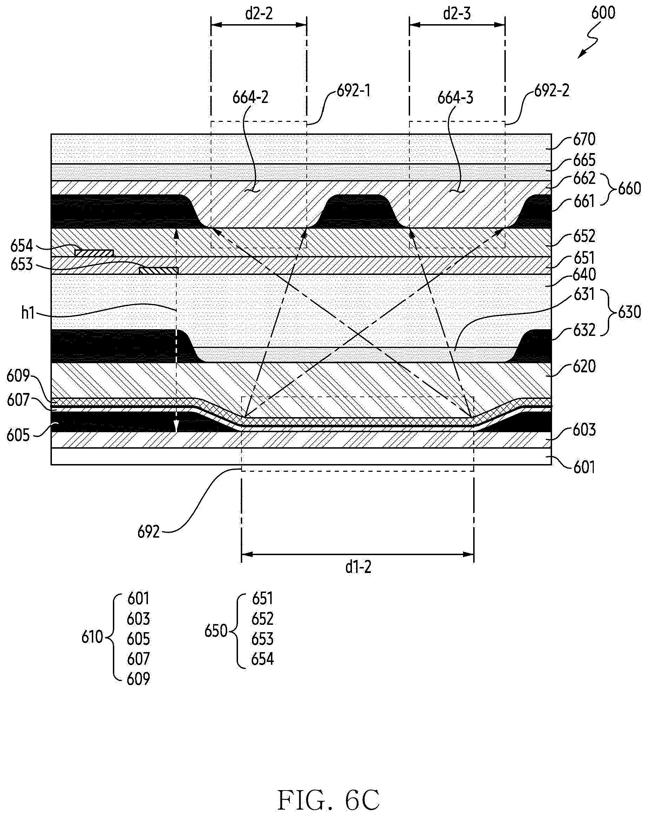

FIG. 6A illustrates a disposition of a first pixel of a display device according to an embodiment and FIG. 6B illustrates a disposition of a second pixel of the display device according to an embodiment. FIG. 6C illustrates a disposition in which a light blocking member of a color filter layer and a part of a pixel define portion are omitted in a portion corresponding to the second pixel of the display device according to an embodiment.

Referring to FIGS. 6A, 6B, and 6C, a display panel 600 may include a pixel layer 610, an encapsulation layer 620, a color filter layer 630, a compensation layer 640, a touch electrode 650, an organic insulation layer 660, and a transparent member 670.

According to an embodiment, the pixel layer 610 may include a semiconductor layer 601, a first electrode layer 603, a pixel define layer 605, an organic light emitting layer 607, and a second electrode layer 609. The semiconductor layer 601 may be a layer including a thin film transistor (TFT). The semiconductor layer 601 may be prepared based on low temperature polycrystalline silicon (LTPS) or low temperature polycrystalline oxide (LTPO). The semiconductor layer 601 may be disposed on a substrate. The substrate may include a bendable material such as polyimide (PI). It is not limited thereto, and may include a material having rigidity. The semiconductor layer 601 may be disposed below the first electrode layer 603 including an anode electrode. A switch in the semiconductor layer 601 may be electrically connected to the anode electrode in the first electrode layer 603. The organic light emitting layer 607 may be disposed on the first electrode layer 603. For example, the organic light emitting layer 607 may be deposited to cover the anode electrode printed on the first electrode layer 603. The organic light emitting layer 607 may be disposed between the second electrode layer 609 including a cathode electrode and the first electrode layer 603 including the anode electrode. The anode electrode in the first electrode layer 603 may form an electric field in the organic light emitting layer 607 together with the cathode electrode in the second electrode layer 609. The anode electrode and the cathode electrode may form the electric field by the thin film transistor in the semiconductor layer 601. By the electric field formed between the electrodes, the organic material in the organic light emitting layer 607 may emit light to an outside. The organic light emitting layer 607 may include organic materials to emit red, green, or blue light. The pixel define layer 605 may be formed in a form that surrounds the light emitting portion of the pixel. The organic material of the organic light emitting layer 607 may be deposited in a space between the pixel define layers 605, and an organic material capable of emitting light having one color may be disposed in a portion partitioned by the pixel define layer 605. Portions corresponding to the portion classified by the pixel define layer 605 may be defined as pixels 691 and 692. The anode electrode of the first electrode layer 603, a light emitting organic material of the organic light emitting layer 607, and the cathode electrode of the second electrode layer 609 may be disposed in the portion classified by the pixel define layer 605.

According to an embodiment, the encapsulation layer 620 may be formed to cover the second electrode layer 609. The encapsulation layer 620 may be disposed between the color filter layer 630 and the second electrode layer 609. The encapsulation layer 620 may be disposed on the second electrode layer 609 to prevent external moisture and oxygen from flowing into the display panel. The encapsulation layer 620 may include an inorganic film layer and an organic film layer to prevent inflow of moisture and oxygen. The inorganic film layer and the organic film layer may be alternately disposed with each other, and the encapsulation layer 620 may include two or more inorganic film layers to prevent the inflow of moisture. For example, the encapsulation layer 620 may be formed of three layers by sequentially stacking the inorganic film layer, the organic film layer, and the inorganic film layer, or may be formed of five layers by sequentially stacking the inorganic film layer, the organic film layer, the inorganic film layer, the organic film layer, and the inorganic film layer. The encapsulation layer 620 may be formed thinly into three layers or may be formed thickly into five or more layers, as necessary.

According to an embodiment, the color filter layer 630 may be disposed on the encapsulation layer 620. The color filter layer 630 may have color filters corresponding to a color of light transmitting a color filter 631 of the color filter layer 630 by emitting from each of the pixels composing the pixel layer 610. For example, in case that the color of light emitted from a first pixel 691 in a first set (e.g., the first set 310 of FIG. 3) is red, the color filter 631 may be a filter capable of transmitting red light. The color filter layer 630 may clearly provide light of color emitted from each pixel by emitting to the outside only light having each color designated in the filters included in the color filter layer 630 among light emitted from the pixel layer 610. According to an embodiment, the color filter layer 630 may be replaced with a polarizing layer.

According to an embodiment, the color filter layer 630 may have a plurality of filters including the color filter 631. A light blocking member 632 may be disposed between the plurality of filters. The light blocking member 632 may be disposed to overlap the pixel define layer 605 at least partially, when looking at the transparent member 670. The light blocking member 632 may be formed to have an opening in a portion where the color filter 631 is positioned. According to an embodiment, the color filter layer 630 may include the light blocking member 632 that is distinguished from a light blocking member 661 of the organic insulation layer 660 and includes an opening corresponding to each of the second pixel 692 or micropixels 6921 and 6922 of the second pixel 692.

According to an embodiment, in case that the display panel 600 has the color filter layer 630, there is no polarizing plate, so external light reflected to the outside by an electrode of the pixel layer 610 may increase. The display panel 600 may include a thin encapsulation layer 620 to reduce reflection of light by the electrode. For example, in case that the encapsulation layer 620 is thick, a path lp of light reflected through the encapsulation layer 620 becomes longer, so the light reflected to the outside may leak to the outside. The display panel 600 may shorten the path lp of reflected light by reducing a thickness of the encapsulation layer 620 and minimize an amount of reflection of light leaking through the light blocking member 632.

According to an embodiment, the compensation layer 640 may be disposed on the color filter layer 630. The compensation layer 640 may be formed to secure a distance h1 between the light blocking member 661 adjacent to the transparent member 670 and the pixel layer 610 (e.g., the first electrode layer 603) in order to secure a narrow viewing angle of the second pixel 692 of a second set (e.g., the second set 320 of FIG. 3). The compensation layer 640 may include a material of an organic film and may include a monomer. The compensation layer 640 may include several layers stacked.

According to an embodiment, the touch electrode 650 may be disposed on the compensation layer 640. The touch electrode 650 may include an insulation layer 651 on which conductive patterns 653 and 654 are formed and a protection layer 652 that protects the conductive patterns 653 and 654. The conductive patterns 653 and 654 may be formed integrally with the display panel by being formed on the compensation layer 640. The conductive patterns 653 and 654 may be conductive patterns interposed on the insulation layer 651 or disposed on the substrate. In order to compensate for performance degradation of the touch electrode 650 due to the thin encapsulation layer 620, another layer may be interposed between the touch electrode 650 and the encapsulation layer 620. For example, the touch electrode 650 may be disposed closer to the transparent member 670. The performance of the touch electrode 650 may be secured by reducing capacitance by securing a distance between the touch electrode 650 and the pixel layer 610. For example, in case that the touch electrode 650 is formed on the encapsulation layer 620, the distance between the touch electrode 650 and the pixel layer 610 is close, capacitance increases, and as charge amount required for charging increases, response speed of the touch panel may be delayed. In case that the touch electrode 650 is disposed on the compensation layer 640, a sufficient distance between the touch electrode 650 and the pixel layer 610 may be secured, and as the capacitance is reduced, the response speed of the touch panel may be improved.

According to an embodiment, the touch electrode 650 may include a first conductive pattern 653 interposed in the insulation layer 651 and a second conductive pattern 654 printed on the insulation layer 651. According to an embodiment, the first conductive pattern 653 may be printed on the compensation layer 640, and the second conductive pattern 654 may be printed on the insulation layer 651 surrounding the first conductive pattern 653. According to another embodiment, the first conductive pattern 653 and the second conductive pattern 654 may be printed on the same layer. For example, the first conductive pattern 653 and the second conductive pattern 654 may be printed on the compensation layer 640. The first conductive pattern 653 may be formed of a plurality of patterns, and the plurality of patterns may be connected by a conductive wire. The conductive wire may be a bridge connecting patterns of the same polarity. The capacitance of the touch electrode 650 by an external object (part of a body) contacting or approaching the transparent member 670 may change. Through the capacitance change, a display device (e.g., the display device 300 of FIG. 3) or an electronic device (e.g., the electronic device 101 of FIG. 1) including the display panel 600 may detect the approach or contact of an external object using the touch electrode 650 and may receive an input based on a coordinate of a detected point.

According to an embodiment, the protection layer 652 may be formed to cover the second conductive pattern 654 of the touch electrode 650 and to protect the second conductive pattern 654 of the touch electrode 650. The protection layer 652 may be referred to as a passivation (PVX) layer. The protection layer 652 may be configured to prevent damage to the second conductive pattern 654. The protection layer 652 may be an insulation layer and may include a single film or multiple films formed of a silicon composite. For example, the protection layer 652 may be a silicon nitride or silicon oxide single film or a multilayer film. However, it is not limited thereto, and the protection layer 652 may be a single film or a multilayer film including an organic material.

According to an embodiment, the organic insulation layer 660 may be disposed between the touch electrode 650 and the transparent member 770. The organic insulation layer 660 may flatten a surface of the display panel for bonding with the transparent member 670. The organic insulation layer 660 may be formed as multiple films of monomers. The organic insulation layer 660 may be attached to the transparent member 670. For example, the adhesive layer 665 may be disposed between the organic insulation layer 660 and the transparent member 670. The organic insulation layer 660 may include an organic material 662 and the light blocking member 661. A width d2-2 of the light blocking member 661 may be determined according to the viewing angle of the second pixel 691. For example, a viewing angle may be formed by a path where light emitted from a right side of the second pixel 691 reaches a left side of the opening formed in the light blocking member 661 and a path where light emitted from a left side of the first pixel 691 reaches a right side of the opening formed in the light blocking member 661.

Referring to FIGS. 6A, 6B, and 6C, the light blocking member 661 may not be disposed in a portion of the organic insulation layer 660 corresponding to the first pixel 691, and the portion corresponding to the first pixel 691 may be formed of an opening formed in the light blocking member 661.

According to an embodiment, an opening that transmits light emitted from the first pixel 691, which is a sub pixel providing a wide viewing angle, to the outside may be formed only in the color filter layer 630. For example, the color filter 631 of the color filter layer 630 may occupy an opening formed in the light blocking member 632 of the color filter layer 630. Openings 664-2 and 664-3 for transmitting light emitted from the second pixel 692, which is a sub pixel that provides a narrow viewing angle, to the outside may be determined according to the number of micropixels (e.g., the micropixels 320-1a, 320-1b, 320-1c, and 320-1d of FIG. 3) configured to divide light emitted from the second pixel 692.

According to an embodiment, a width d1-1 of the first pixel 691 may be narrower than a width d1-2 of the second pixel 692. The amount of light transferred to the outside through the first pixel 691 and the amount of light transferred to the outside of the display panel 600 or the electronic device 101 through the second pixel 692 may be substantially the same. The amount of light transferred through the first pixel 691 may be determined by a light emitting area of the first pixel 691. The amount of light transferred through the second pixel 692 may be determined by the widths d2-2 and d2-3 of the openings 664-2 and 664-3 that overlap the second pixel 692 among the openings of the light blocking member 661.

According to an embodiment, a portion 692-1 and a portion 692-2 corresponding to the micropixels may be spaced apart from each other. In order to distinguish the micropixels, the light blocking member 661 may include a plurality of openings 664-2 and 664-3 on the second pixel 692. The widths d2-2 and d2-3 of the plurality of openings 664-2 and 664-3 may be configured such that the amount of light transferred through the second pixel 692 is substantially the same as the amount of light transferred through the first pixel 691. For example, in case that the second pixel 692 is divided into four micropixels, the widths d2-2 and d2-3 of each of the openings 664-2 and 664-3 forming the portions 692-1 and 692-2 corresponding to the micropixels of the second pixel 692 may be smaller than or equal to half of the width d 1-1 of the first pixel 691.

According to an embodiment, the second pixel 692 may provide a viewing angle narrower than the viewing angle provided by the first pixel 691 due to the plurality of openings 664-2 and 664-3 while transferring the same or similar amount of light as the first pixel 691 to the outside.

According to an embodiment, the plurality of openings 664-2 and 664-3 have the widths d2-2 and d2-3, and the widths d2-2 and d2-3 may be substantially the same length. Since the plurality of openings 664-2 and 664-3 overlapping the second pixel 692 have a narrow width, the viewing angle of light emitted through the second pixel 692 may be narrowed.

Referring to FIGS. 6B and 6C, the light blocking member 661 may include the plurality of openings 664-2 and 664-3 that divide the second pixel 692. The light blocking member 661 positioned on the first pixel 691 and the light blocking member 661 positioned on the second pixel 692 may be formed of the same light blocking member 661. For example, the light blocking member 661 may be formed by applying one light blocking material and using a negative-type photoresist (Nega PR) process. For example, a light blocking material may be applied on the touch electrode 650 and a mask may be disposed on the applied light blocking material. When light is irradiated toward the light blocking material covered by the mask, only the light blocking material exposed through a pattern penetrating the mask may remain. When developer included in the light blocking material encounters light, its solubility decreases, and it may not dissolve. The light blocking material in the light-irradiated portion remains to form the light blocking member 661, and the light blocking material in the remaining portion may dissolve and disappear.

According to an embodiment, when the light blocking member 661 is formed, a portion corresponding to the first pixel 691 may be covered with a mask, and a portion corresponding to the second pixel 692 may be covered with a mask in a portion corresponding to the plurality of openings. The plurality of openings may correspond to the micropixels (e.g., the micropixels 320-1a, 320-1b, 320-1c, and 320-1d of FIG. 3). For example, the plurality of openings 664-2 and 664-3 may be formed in the portions 692-1 and 692-2 corresponding to the micropixels.

The organic insulation layer 660 may be attached to the transparent member 670. For example, the adhesive layer 665 may be disposed between the organic insulation layer 660 and the transparent member 670. In case that the light blocking member 661 may be flattened by thickening the adhesive layer 665, the organic material 662 of the organic insulation layer 660 may be omitted.

Referring to FIG. 6B, a viewing angle of the first micropixel 6921 corresponding to the portion 692-1 may be determined by a path of light emitted from the left side of the first micropixel 6921 of the second pixel 692 toward a right edge of the left opening 664-2 formed in the light blocking member 661 and a path of light emitted from the right side of the first micropixel 6921 of the second pixel 692 toward a left edge of the left opening 664-2 formed in the light blocking member 661. The viewing angle of the second micropixel 6922 may be determined by the right opening 664-3 formed in the light blocking member 661, similar to the viewing angle of the first micropixel 6921.

According to an embodiment, since the light blocking member 661 disposed in the portion corresponding to the second pixel 692 has the openings 664-2 and 664-3 through which light emitted from the second pixels 692 passes, the viewing angle provided by the second pixel 692 may be narrower than the viewing angle provided by the first pixel 691.

According to an embodiment, the viewing angle of the second micropixel 6922 may be determined by the right opening 664-3 formed in the light blocking member 661, similar to the viewing angle of the first micropixel 6921.

According to an embodiment, the second pixel 692 has a plurality of micropixels 6921 and 6922, and light emitted from each of the micropixels 6921 and 6922 may form a narrow viewing angle by the openings 664-2 and 664-3 of the light blocking member 661. Light emitted from the first micropixel 6921 may be transferred through the color filter 631 disposed in the left opening of the light blocking member 632 of the color filter 631 and the left opening 664-2 of the light blocking member of the organic insulation layer 660, so a narrow viewing angle may be configured. Light emitted from the second micropixel 6922 may be transferred through the color filter 631 disposed in the right opening of the light blocking member 632 of the color filter 631 and the right opening 664-3 of the light blocking member 661 of the organic insulation layer 660, so the narrow viewing angle may be formed.

According to an embodiment, the color filter layer 630 may further include an additional light blocking member 6321 at a position corresponding to an additional pixel define portion 6051 that classifies the micropixels 6921 and 6922. The additional light blocking member 6321 may be integrally formed with the light blocking member 632 of the color filter layer 630. The light blocking member 632 and the additional light blocking member 6321 of the color filter layer 630 may prevent external light reflected from the pixel layer 610 from being viewed from the outside. According to an embodiment, at least one of the additional light blocking member 6321 and the additional pixel define portion 6051 may be omitted in case where a narrow viewing angle of the second pixel 692 may be implemented. A case in which both the additional light blocking member 6321 and the additional pixel define portion 6051 are omitted will be described with reference to FIG. 6C.

Referring to FIG. 6C, a viewing angle of the first micropixel corresponding to the portion 692-1 may be determined by a path of light emitted from the left side of the second pixel 692 toward the right edge of the left opening 664-2 formed in the light blocking member 661 and a path of light emitted from the right side of the second pixel 692 toward the left edge of the left opening 664-2 formed in the light blocking member 661.

According to an embodiment, since the light blocking member 661 disposed in the portion corresponding to the second pixel 692 has the openings 664-2 and 664-3 through which light emitted from the second pixels 692 passes, the viewing angle provided by the second pixel 692 may be narrower than the viewing angle provided by the first pixel 691.

According to an embodiment, the viewing angle of the second micropixel corresponding to the portion 692-2 may be determined by the right opening 664-3 formed in the light blocking member 661, similar to the viewing angle of the first micropixel corresponding to the portion 692-1. The viewing angle of the second micropixel corresponding to the portion 692-2 may be determined by a path of light emitted from the left side of the second pixel 692 toward the right edge of the right opening 664-3 formed in the light blocking member 661 and a path of light emitted from the right side of the second pixel 692 toward the left edge of the right opening 664-3 formed in the light blocking member 661.

According to an embodiment, a light emitting area that emits light to the color filter 631 through the second pixel 692 may be formed to be wider than or equal to a light emitting area of the first pixel 691. The width d 1-2 of the second pixel 692 may be wider than the width of the first pixel 691 so that the amount of light transmitting from the second pixel 692 through the openings 664-2 and 664-3 of the light blocking member 661 is configured to be the same as the amount of light transmitting from the first pixel 691 through the opening 664-1 of the light blocking member 661.

According to the above-described embodiment, the display device 300 or the electronic device 101 including the display panel 600 may provide a narrow viewing angle according to a surrounding environment or input by disposing the second pixel 692 having a narrower viewing angle than the first pixel 691 having a viewing angle. The display panel 600 may include the compensation layer 640 to compensate for the reduced thickness of the encapsulation layer 620 to prevent external reflection of light by including the color filter layer 630 instead of the polarizing plate. The display panel 600 including the compensation layer 640 may secure a distance for implementing a narrow viewing angle by securing a gap between the light blocking member 661 and the pixel layer 610. By forming the distance h1 between the light blocking member 661 and the pixel layer 610 longer than the width d 1-2 of the second pixel 692, the second pixel 692 of the display panel 600 may provide a narrow viewing angle. The second pixel 692 may provide a viewing angle narrower than the viewing angle of the first pixel 691 through the widths d2-2 and d2-3 of the reduced openings 664-2 and 664-3 since it may be divided into micropixels by the light blocking member 661.

According to an embodiment, in case that the touch electrode 650 is disposed on the encapsulation layer 620, the capacitance between the touch electrode 650 and the pixel layer 610 may increase due to the thinned encapsulation layer 620. In order to reduce the capacitance of the touch electrode 650, the touch electrode 650 may be disposed on the compensation layer 640. The touch electrode 650 may be configured to have a fast response speed of the touch electrode 650 by compensating for the thickness of the thinned encapsulation layer 620, by being disposed on the compensation layer 640 for compensating the viewing angle.

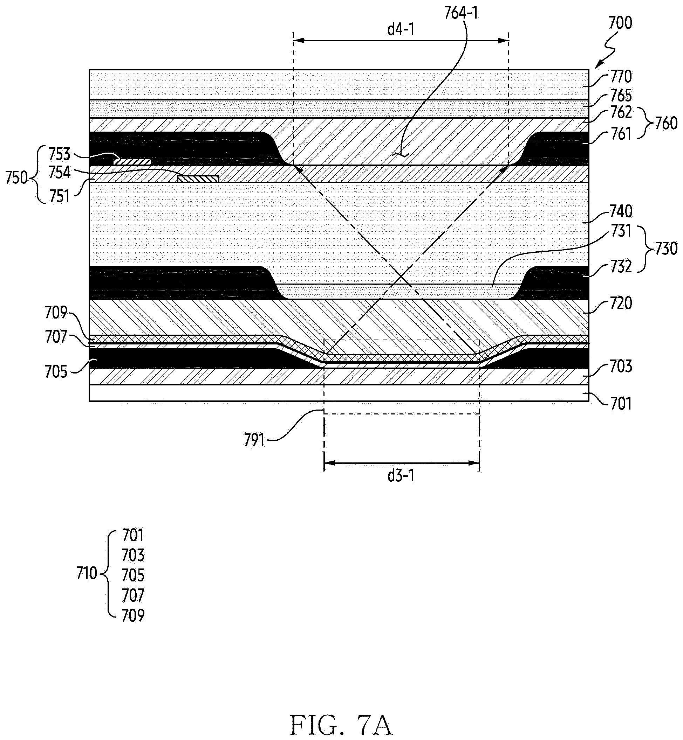

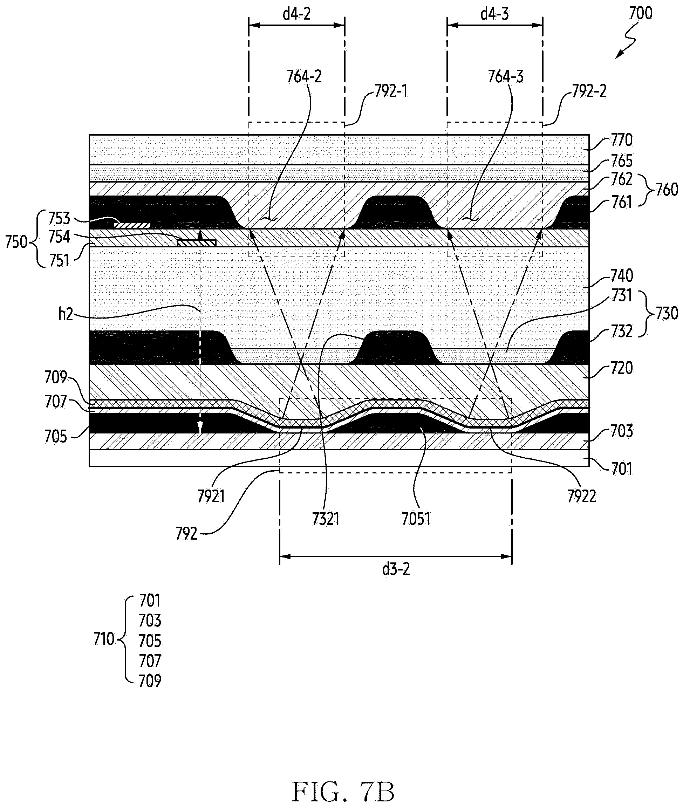

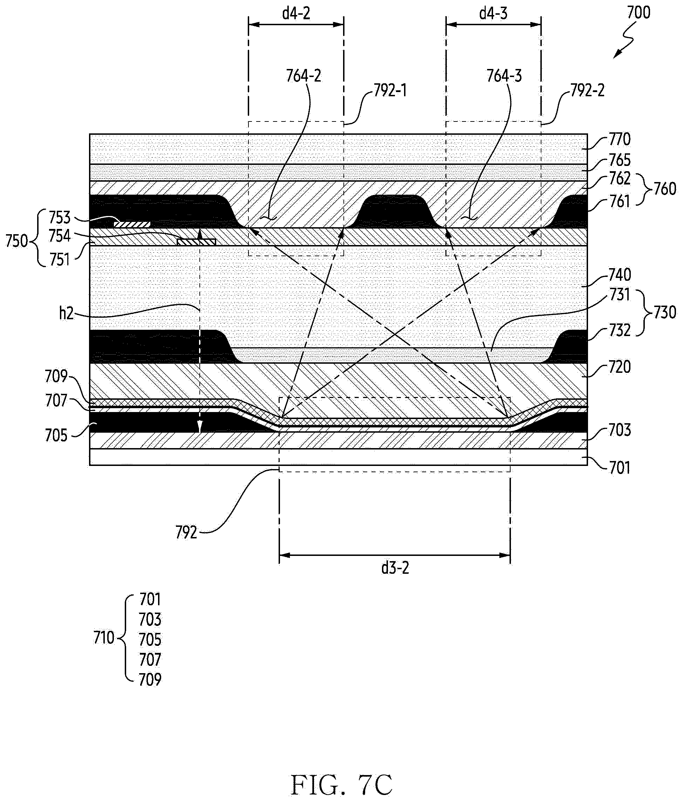

FIG. 7A is an example illustrating a configuration in which a protection layer of a touch panel is included in a light blocking member in a portion where a first pixel of a display device is disposed according to an embodiment, FIG. 7B is an example illustrating a configuration in which the protection layer of the touch panel is included in the light blocking member in a portion where a second pixel of the display device is disposed according to an embodiment, and FIG. 7C illustrates a disposition in which the light blocking member of a color filter layer and a part of a pixel define portion are omitted while the protection layer of the touch panel is included in the light blocking member in a portion corresponding to the second pixel of the display device according to an embodiment.

Referring to FIGS. 7A to 7C, a display panel 700 may include a pixel layer 710, an encapsulation layer 720, a color filter layer 730, a compensation layer 740, a touch electrode 750, an organic insulation layer 760, and a transparent member 770.

A configuration of the compensation layer 740, the touch electrode 750, and the organic insulation layer 760 in the display panel 700 of FIGS. 7A, 7B, and 7C may have a different configuration from that of the display panel 600 of FIGS. 6A, 6B, and 6C, and the remaining configuration may have the same or similar configuration as that of the display panel 600 of FIGS. 6A, 6B, and 6C.

According to an embodiment, the pixel layer 710 may include a semiconductor layer 701, a first electrode layer 703, an organic light emitting layer 707, a second electrode layer 709, and a pixel define layer 705. The semiconductor layer 701 may be a thin film transistor layer and may be electrically connected to an anode electrode of the first electrode layer 703 and a cathode electrode of the second electrode layer 709. The semiconductor layer 601 may be disposed on a substrate. The semiconductor layer 701 may be disposed below the first electrode layer 703 including the anode electrode. The semiconductor layer 701 may emit light through an organic material of the organic light emitting layer 707 disposed between the first electrode layer 703 and the second electrode layer 709 by forming an electric field between the anode electrode and the cathode electrode. The organic light emitting layer 707 may be configured to emit red, green, or blue light.

According to an embodiment, the pixel define layer 705 may be formed in a form that surrounds a light emitting portion of the pixel. Portions corresponding to the portion classified by the pixel define layer 705 may be defined as sub pixels 791 and 792. In the pixel define layer 705, the anode electrode of the first electrode layer 703 may be disposed, a light emitting organic material of the organic light emitting layer 707 may be disposed, and the cathode electrode of the second electrode layer 709 may be disposed.

According to an embodiment, the encapsulation layer 720 may be formed to cover the anode electrode of the second electrode layer 709. The encapsulation layer 720 may prevent inflow of external moisture and oxygen. The encapsulation layer 720 may alternately stack an inorganic film layer and an organic film layer to prevent oxygen from flowing into the display panel.

According to an embodiment, the color filter layer 730 may be disposed on the encapsulation layer 720. The color filter layer 730 may have color filters of a color corresponding to a color of light emitted from each of the pixels composing the pixel layer 710 and transmitting through the filter 731 of the color filter layer 730.

According to an embodiment, the color filter layer 730 may have a plurality of filters including the filter 731. A light blocking member 732 may be disposed between the plurality of filters. The light blocking member 732 may be disposed to overlap the pixel define layer 705 at least partially, when looking at the transparent member 770. The light blocking member 732 may be formed to have an opening in a portion where the filter 731 is positioned.

According to an embodiment, the compensation layer 740 may be disposed on the color filter layer 730. The compensation layer 740 may have a thickness capable of securing a distance h2 between the light blocking member 761 adjacent to the transparent member 770 and the pixel layer 710 in order to secure a narrow viewing angle of the second pixel 792 of a second set (e.g., the second set 320 of FIG. 3).

According to an embodiment, the touch electrode 750 may be disposed between the compensation layer 740 and the organic insulation layer 760. The touch electrode 750 may include a first conductive pattern 753 interposed in an insulation layer 751 and a second conductive pattern 754 printed on the insulation layer 751. The capacitance of the touch electrode 750 may change due to an external object (part of a body) contacting or approaching the transparent member 770. A display device (e.g., the display device 300 of FIG. 3) or an electronic device (e.g., the electronic device 101 of FIG. 1) including the display panel 700 may detect the approach or contact of the external object by using the touch electrode 750 and receive an input based on a coordinate of a detected point.

Compared to the display panel 600 of FIGS. 6A to 6C, the touch electrode 750 may not include a protection layer (e.g., the protection layer 652 of FIG. 6A to the protection layer 652 of FIG. 6C) for protecting the second conductive pattern 754 printed on the insulation layer 751. The second conductive pattern 754 may prevent damage to the second conductive pattern 754 by protecting the second conductive pattern 754 through the light blocking member 761 formed of substantially the same insulation material as the protection layer 652. As the protection layer of the touch electrode 750 is removed, the reduced thickness may be compensated by forming the compensation layer 740 thick.

According to an embodiment, the light blocking member 761 may cover the second conductive pattern 754. The light blocking member 761 may prevent damage to the second conductive pattern 754 by covering the second conductive pattern 754. The light blocking member 761 may be an insulation layer formed of an organic material, and may be formed in a color (e.g., black) with a high absorption rate of light. The light blocking member 761 may perform a function of the protection layer by being formed of a material similar to the protection layer 652 of FIGS. 6A to 6C. According to another embodiment, the first conductive pattern 753 may be printed on the compensation layer 740 and the second conductive pattern 754 may be printed on the insulation layer 751 surrounding the first conductive pattern 753. According to another embodiment, the first conductive pattern 753 and the second conductive pattern 754 may be printed on the same layer. For example, the first conductive pattern 753 and the second conductive pattern 754 may be printed on the compensation layer 740. The first conductive pattern 753 may be formed of a plurality of patterns, and the plurality of patterns may be connected by a conductive wire. The conductive wire may be a bridge connecting patterns of the same polarity. In case that the first conductive pattern 753 and the second conductive pattern 754 are printed on one layer, the light blocking member 761 may cover the first conductive pattern 753 and the second conductive pattern 754. The light blocking member 761 may prevent damage to the first conductive pattern 753 and the second conductive pattern 754 by covering the first conductive pattern 753 and the second conductive pattern 754.

According to an embodiment, the organic insulation layer 760 may be disposed between the touch electrode 750 and the transparent member 770. The organic insulation layer 760 may flatten a surface of the display panel 700 for bonding with the transparent member 770. The organic insulation layer 760 may be formed as multiple films of monomers. The organic insulation layer 760 may include an organic material 762 and the light blocking member 761. A width d4-1 of an opening 764-1 of the light blocking member 761 may be determined according to a viewing angle of the first pixel 791, and widths d4-2 and d4-3 of openings 764-2 and 764-3 overlapping the second pixel 792 may be determined according to a viewing angle provided by the second pixel 792.

According to an embodiment, the organic insulation layer 760 may be attached to the transparent member 770. For example, the adhesive layer 765 may be disposed between the organic insulation layer 760 and the transparent member 770.

Referring to FIG. 7A, unlike FIG. 6A, the organic insulation layer 760 may include the light blocking member 761 and the organic material 762. In order to protect the conductive pattern 753, the light blocking member 761 may be disposed on the conductive pattern 753 in a portion corresponding to the first pixel 791. The touch electrode 750 includes conductive patterns 753 and 754 formed on the insulation layer 751, and the conductive pattern 753 formed on the top of the insulation layer 751 may not be covered by the protection layer (e.g., the protection layer 652 of FIG. 6A). In order to prevent damage to the conductive pattern 753, the light blocking member 761 may protect the pattern 753 formed on the top of the insulation layer 751.

According to an embodiment, among the optical paths through which light emitted from the first pixel 791 passes through the opening 764-1, the largest angle among the angles formed by two optical paths may be related to the viewing angle. The light blocking member 761 may determine the width d4-1 of the opening 764-1 to secure movement of light emitted from the first pixel 791 in order to secure a wide viewing angle of the first pixel 791 while performing a function of protecting the conductive pattern 753.

Referring to FIG. 7B, the light blocking member 761 may include a plurality of openings 764-2 and 764-3 that divide the second pixel 792. The light blocking member 761 positioned on the first pixel 791 and the light blocking member 761 positioned on the second pixel 792 may be formed of substantially the same light blocking member 761. For example, the light blocking member 761 may be formed by applying one light blocking material and using Nega PR.

According to an embodiment, a width d3-2 of the second pixel 792 may be formed to be wider than a width d3-1 of the first pixel 791 to secure a light emitting area.

According to an embodiment, the light blocking member 761 formed on the touch electrode 750 may include the plurality of openings 764-2 and 764-3. The widths d4-2 and d4-3 of the plurality of openings 764-2 and 764-3 may be determined by viewing angles of a first micropixel 7921, and a second micropixel 7922. The widths d4-2 and d4-3 of the plurality of openings 764-2 and 764-3 may be the same as the widths of the portions 792-1 and 792-2 corresponding to the micropixels 7921 and 7922.

According to an embodiment, the viewing angle of the first micropixel 7921 corresponding to the portion 792-1 may be determined by a path of light emitted from a left side of the first micropixel 7921 of the second pixel 792 toward a right edge of a left opening 764-2 formed in the light blocking member 761 of the organic insulation layer 760 and a path of light emitted from a right side of the first micropixel 7921 of the second pixel 792 toward a left edge of the left opening 764-2 formed in the light blocking member 761. The viewing angle of the second micropixel 7922 may be determined by a right opening 764-3 formed in the light blocking member 761, similar to the viewing angle of the first micropixel 7921.

According to an embodiment, since the light blocking member 761 disposed in a portion corresponding to the second pixel 792 has the openings 764-2 and 764-3 through which light emitted from the second pixels 792 passes, the viewing angle provided by the second pixel 792 may be narrower than the viewing angle provided by the first pixel 791.

According to an embodiment, the second pixel 792 has a plurality of micropixels 7921 and 7922, and light emitted from each of the micropixels 7921 and 7922 may form a narrow viewing angle by the openings 764-2 and 764-3 of the light blocking member 761. Light emitted from the first micropixel 7921 may be transferred through the color filter 731 disposed in the left opening of the light blocking member 732 of the color filter 731 and the left opening 764-2 of the light blocking member of the organic insulation layer 760, so a narrow viewing angle may be configured. Light emitted from the second micropixel 7922 may be transferred through the color filter 731 disposed in the right opening of the light blocking member 732 of the color filter 731 and the right opening 764-3 of the light blocking member 761 of the organic insulation layer 760, so the narrow viewing angle may be formed.

According to an embodiment, the color filter layer 730 may further include an additional light blocking member 7321 at a position corresponding to an additional pixel define portion 7051 that classifies the micropixels 7921 and 7922. The additional light blocking member 7321 may be integrally formed with the light blocking member 732 of the color filter layer 730. The light blocking member 732 and the additional light blocking member 7321 of the color filter layer 730 may prevent external light reflected from the pixel layer 710 from being viewed from the outside. According to an embodiment, at least one of the additional light blocking member 7321 and the additional pixel define portion 7051 may be omitted in case where a narrow viewing angle of the second pixel 792 may be implemented. A case in which both the additional light blocking member 7321 and the additional pixel define portion 7051 are omitted will be described with reference to FIG. 7C.

Referring to FIG. 7C, only one opening 764-1 of the light blocking member 761 for transferring light emitted from the first pixel 791, which is a sub pixel that provides a wide viewing angle, to the outside, may be formed. The number of the openings 764-2 and 764-3 of the light blocking member 761 for transferring light emitted from the second pixel 792, which is a sub pixel that provides a narrow viewing angle, to the outside, may be determined according to the number of micropixels (e.g., the micropixels 320-1a, 320-1b, 320-1c, and 320-1d of FIG. 3) configured to divide light emitted from the second pixel 792.

According to an embodiment, the width d3-2 of the second pixel 792 may be wider than the width d3-1 of the first pixel 791 having a first viewing angle that is wider than a second viewing angle of the second pixel 792.

According to an embodiment, the portion 792-1 and the portion 792-2 corresponding to the micropixels that divide light emitted from the second pixel 792 may be spaced apart from each other. The plurality of openings 764-2 and 764-3 of the light blocking member 761 may provide the narrow viewing angle of the second pixel 792. Each of the plurality of openings 764-2 and 764-3 may have the widths d4-2 and d4-3 for providing the narrow viewing angle of the second pixel 792.

For another example, in order to classify the micropixels, the light blocking member 761 may include the plurality of openings 764-2 and 764-3 on the second pixel 792. A sum of the widths d4-2 and d4-3 of the plurality of openings 764-2 and 764-3 positioned on the second pixel 792 may be substantially the same as the width d4-1 of the opening 764-1 positioned on the first pixel 791. The widths d4-2 and d4-3 of the plurality of openings 764-2 and 764-3 may be configured such that an amount of light transferred through the second pixel 792 is substantially the same as an amount of light transferred through the first pixel 791.

According to an embodiment, the display panel 700 may include a thin encapsulation layer 720 to prevent reflection of external light by disposing the color filter layer 730 instead of the polarizing plate on the encapsulation layer 720. In order to secure a touch performance of the touch electrode 750 according to the thickness of the thinned encapsulation layer 720, the touch electrode 750 may be disposed on the compensation layer 740 and the first conductive pattern 753 and the second conductive pattern 754 of the touch electrode 750 may be disposed to overlap the light blocking member 761 of the organic insulation layer 760. The light blocking member 761 may be formed in a same process as the light blocking member 761 and may perform a function of the protection layer for preventing damage to the second conductive pattern 754.

According to an embodiment, the patterns 753 and 754 of the touch electrode 750 may be disposed to overlap the pixel define layer 705. The patterns 753 and 754 of the touch electrode 750 may be disposed along the light blocking member 761 that classifies the subpixels 791 and 792 (e.g., the subpixels 310-1, 310-2, 310-3, 310-4, 320-1, 320-2, 320-3, and 320-4 of FIG. 3).

Referring again to FIGS. 7B and 7C, the light blocking member 761 may include the openings 764-2 and 764-3 that divide light emitted from the second pixel 792 into units of the portions 792-1 and 792-2 corresponding to the micropixels. The patterns 753 and 754 of the touch electrode 750 may not be disposed in a portion disposed between the openings 764-2 and 764-3 divided into units of the portions 792-1 and 792-2 corresponding to the micropixels among the light blocking member 761. For example, the patterns 753 and 754 of the touch electrode 750 may be disposed in a portion divided into sub pixel units among the light blocking member 761. According to an embodiment, the light blocking member 761 in the portion divided into sub pixel units may surround the second conductive pattern 754. In a process of manufacturing the touch electrode 750, a process of forming the protection layer (e.g., the protection layer 652 of FIGS. 6A to 6C) is removed, so a production process of the display panel may be simplified.

According to the above-described embodiment, the display device 300 or the electronic device 101 including the display panel 700 may secure a distance for securing the performance of the touch electrode 750 and preventing a delay in reaction time by disposing the compensation layer 740 and disposing the touch electrode 750 on the compensation layer 740 in order to secure a narrow viewing angle.

According to an embodiment, an electrode pattern of the touch electrode 750 may be protected by the light blocking member 761 disposed in the organic insulation layer 760 as the touch electrode 750 is disposed between the compensation layer 740 and the organic insulation layer 760. The manufacturing time of the display panel 700 may be reduced and the production process may be simplified by reducing the process for forming the protection layer to protect the electrode pattern of the touch electrode 750.

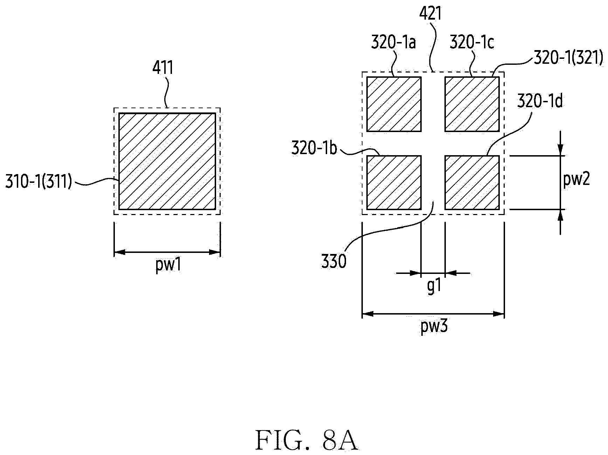

FIG. 8A illustrates an example of a sub pixel of a first pixel and a sub pixel of a second pixel of a display device according to an embodiment.

Referring to FIG. 8A, a first sub pixel 310-1 of a first pixel 311 may have a first width pw1. A first sub pixel 320-1 of a second pixel 321 may have a third width pw3. Each of the sub pixels of the second pixel 321 may be divided into a plurality of micropixels 320-1a, 320-1b, 320-1c, and 320-1d. The first sub pixel 310-1 of the first pixel 311 may be operated by a first anode electrode 411, and the first sub pixel 320-1 of the second pixel 321 may be operated by a second anode electrode 421. The first sub pixel 320-1 of the second pixel 321 may include the plurality of micropixels 320-1a, 320-1b, 320-1c, and 320-1d. The plurality of micropixels 320-1a, 320-1b, 320-1c, and 320-1d may be operated by one second anode electrode 421.

According to an embodiment, the first sub pixel 320-1 of the second pixel 321 may be divided into the plurality of micropixels 320-1a, 320-1b, 320-1c, and 320-1d. The plurality of micropixels 320-1a, 320-1b, 320-1c, and 320-1d composing the first sub pixel 320-1 of the second pixel 321 may emit the same color to an outside. For example, the micropixels 320-1a, 320-1b, 320-1c, and 320-1d composing the first sub pixel 320-1 that emits red light may transfer red light to the outside. The micropixels 320-1a, 320-1b, 320-1c, and 320-1d may be spaced apart from each other at a distance g1. In order to equalize an amount of light transferred by the first sub pixel 310-1 of the first pixel 311 to an amount of light transferred by the first sub pixel 320-1 of the second pixel 321, a sum of areas of the micropixels 320-1a, 320-1b, 320-1c, and 320-1d of the first sub pixel 320-1 of the second pixel 321 may be the same as an area of the first sub pixel 310-1 of the first pixel 311. A light emitting area of the sub pixel of the first pixel 311 may be the same as a light emitting area of the sub pixel of the second pixel.

According to an embodiment, a light emitting area of the sub pixel of the first pixel 311 providing the first color and the second pixel 321 providing the first color may be the same. An area of the first sub pixel 310-1 of the first pixel 311 providing red light may be four times larger than an area of each of the micropixels 320-1a, 320-1b, 320-1c, and 320-1d of the first sub pixel 320-1 of the second pixel 321 providing red light. For example, in case that the area of each of the micropixels 320-1a, 320-1b, 320-1c, and 320-1d is the same, the area of each of the micropixels 320-1a, 320-1b, 320-1c, and 320-1d may be a quarter of the first sub pixel 310-1 of the first pixel 311, since the number of the micropixels 320-1a, 320-1b, 320-1c, and 320-1d is four. The first width pw1 of the first sub pixel 310-1 of the first pixel 311 may be twice the second width pw2 of each of the micropixels 320-1a, 320-1b, 320-1c, and 320-1d composing the first sub pixel 320-1 of the second pixel 321.

According to an embodiment, a light blocking member 330 may be disposed between the micropixels 320-1a, 320-1b, 320-1c, and 320-1d to provide a narrow viewing angle. The micropixels 320-1a, 320-1b, 320-1c, and 320-1d may be spaced apart at a gap g1, which is the width of the light blocking member 330. The third width pw3 of the first sub pixel 320-1 of the second pixel 321 may be a sum 2*pw2+g1 of the width 2*pw2 of the two micropixels and the gap g1, which is the width of the light blocking member 330.

According to an embodiment, corresponding to the first width pw1 of the first sub pixel 310-1 of the first pixel 311, the size of the first anode electrode 411 disposed in the first sub pixel 310-1 may be determined. Corresponding to the third width pw3 of the first sub pixel 320-1 of the second pixel 321, the size of the second anode electrode 421 disposed in the first sub pixel 320-1 of the second pixel 321 may be determined. The size of the first sub pixel 320-1 of the second pixel 321 may be larger than the size of the first sub pixel 310-1 of the first pixel 311.

According to an embodiment, the size of the sub pixel of the second pixel 321 having a viewing angle narrower than that of the first pixel 311 may be larger than the size of the sub pixel of the first pixel 311. The first pixel 311 and the second pixel 321 may include sub pixels having an organic light emitting diode that emits red, blue, or green light. For example, each of the first pixel 311 and the second pixel 321 may include a sub pixel emitting red light, a sub pixel emitting blue light, and two sub pixels emitting green light. However, it is not limited thereto, and the pixel may include various combinations of sub pixels.

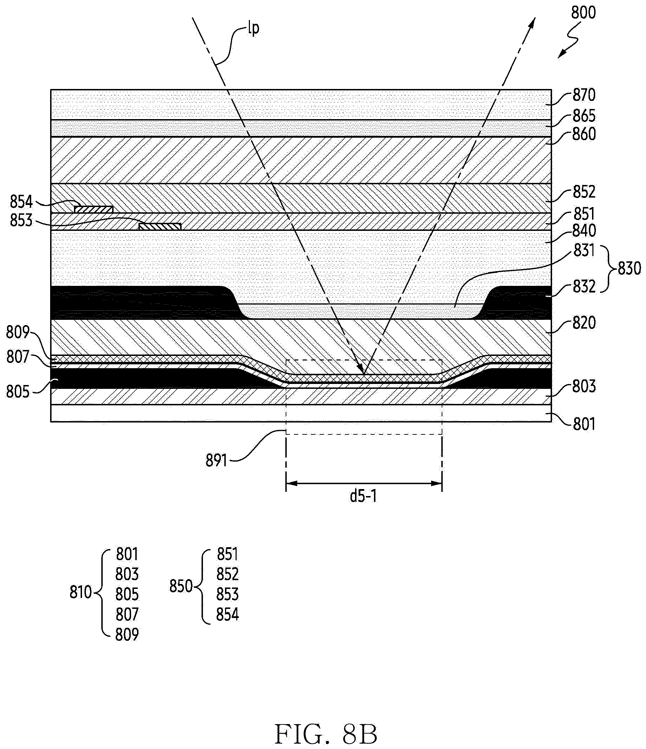

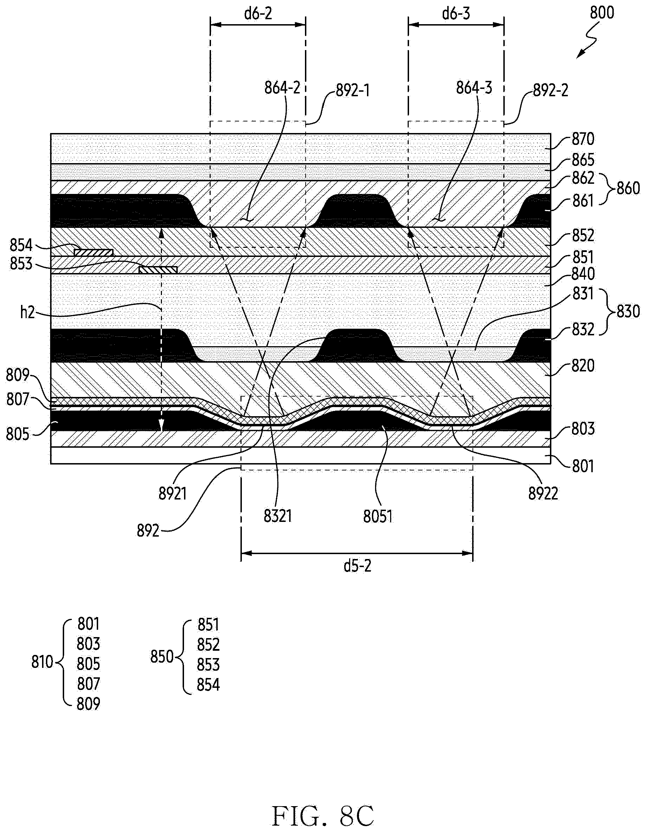

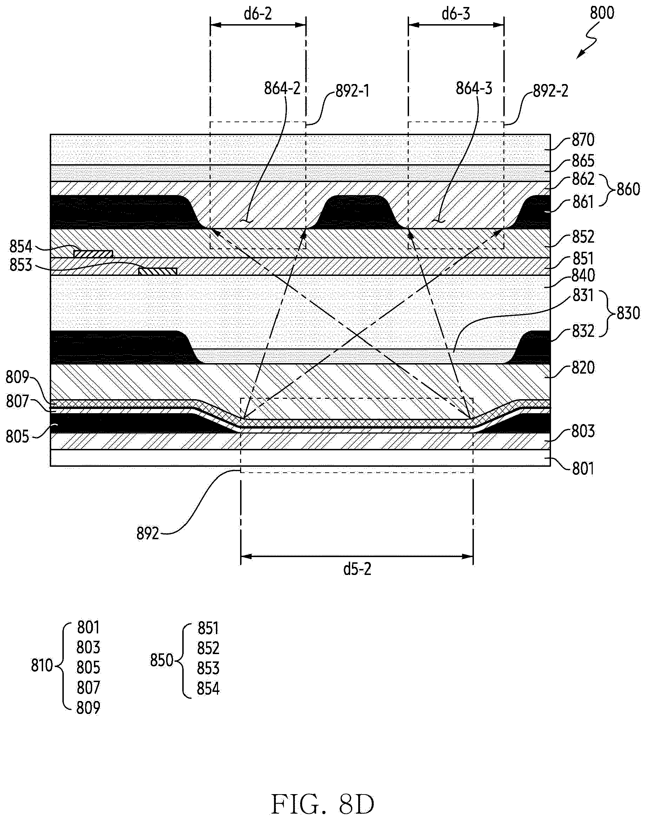

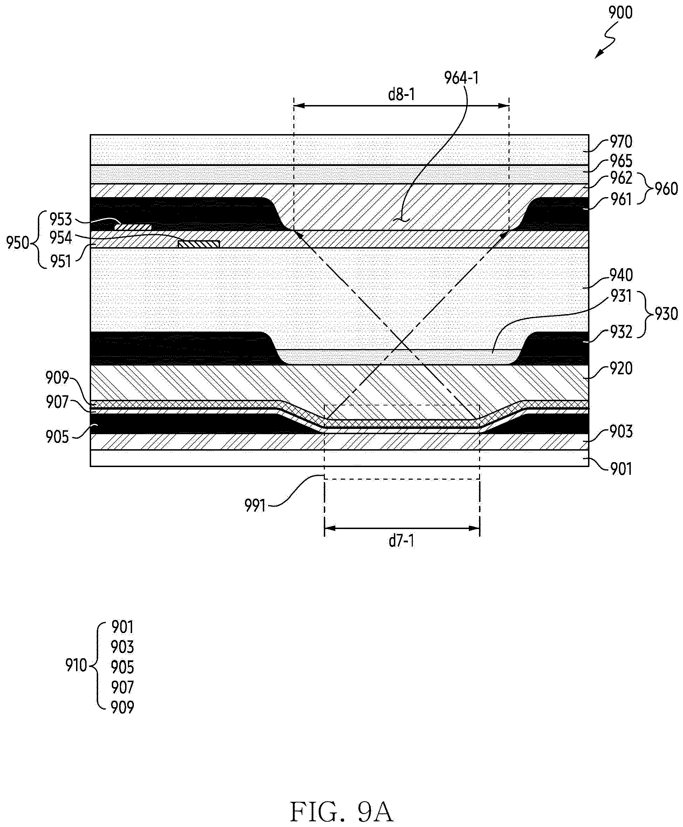

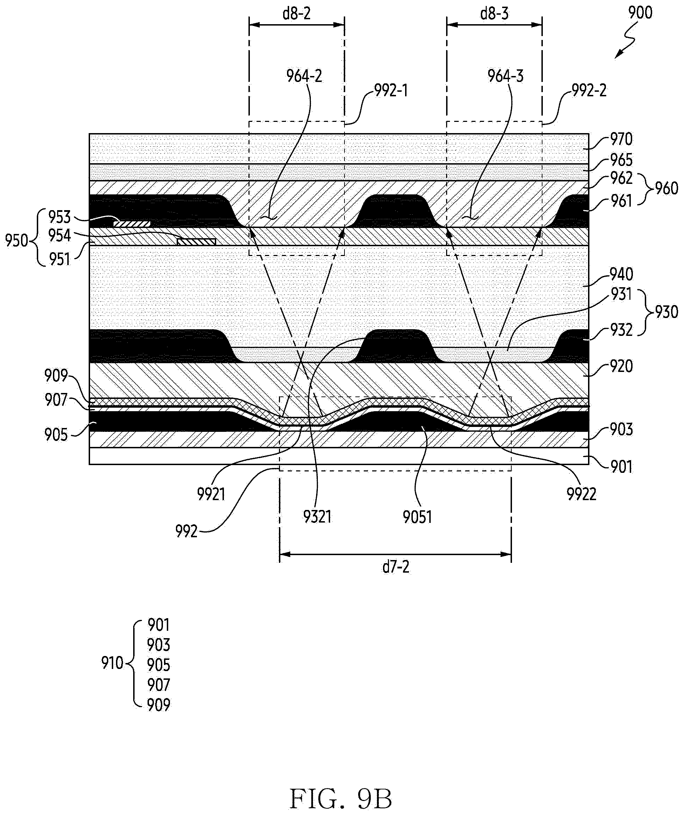

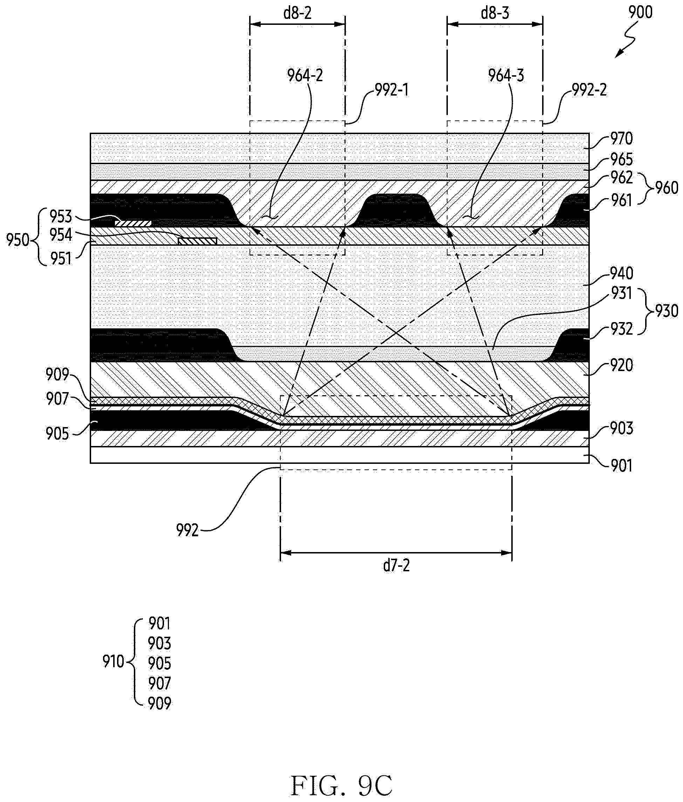

According to an embodiment, the second pixel 321 may be larger than the first pixel 311 by the gap g1 between the micropixels 320-1a, 320-1b, 320-1c, and 320-1d composing the first sub pixel 320-1. The size of the second anode electrode 421 for driving the second pixel 321 may be larger than the size of the first anode electrode 411 for driving the first pixel 311. The overall size of the second pixel 321 may also be larger than the overall size of the first pixel 311. For example, the first pixel 311 may have a sufficient gap between four sub pixels (e.g., the sub pixels 310-1, 310-2, 310-3, and 310-4 of FIG. 3), but in the second pixel 321, the gap between the four sub pixels 320-1, 320-2, 320-3, and 320-4 may decrease as the size of the sub pixels 320-1, 320-2, 320-3, and 320-4 increases. Due to the size of the second pixel 321 increasing in overall size, the gap between the pixels may decrease. As the gap between the pixels decreases, color mixing may occur during deposition of the organic light emitting diode. For example, when depositing the second pixel 321, where the gap between the pixels is narrowed, an organic light emitting diode emitting red light is deposited at a designated pixel position, and in case that an organic light emitting diode emitting green light is deposited at a pixel position adjacent to the designated pixel position, the organic light emitting diode emitting green light may be partially deposited on the pixel designated for deposition of an organic light emitting diode emitting red light. In order to prevent color mixing of the organic light emitting diode, the gap between the pixels must be widened, but there may be limitations in widening the gap between the pixels at high resolution. FIGS. 8B, 8C, 8D, 9A, 9B, and 9C describe a method for implementing a narrow viewing angle at high resolution.

FIG. 8B illustrates a disposition of a first pixel of a display device (e.g., WOLED display device) according to another embodiment, FIG. 8C illustrates a disposition of a second pixel of the display device (e.g., WOLED display device) according to another embodiment, and FIG. 8D illustrates a disposition in which a light blocking member of a color filter layer and a part of a pixel define portion are omitted in a portion corresponding to the second pixel of the display device (e.g., a WOLED display device), according to another embodiment.

According to an embodiment, when a display panel 800 to which a WOLED is applied is formed, since white light, which is light of the same color, is emitted, concerns about color mixing due to a deposition process is eliminated, so an organic light emitting diode may be deposited even in a narrow gap between pixels (e.g., sub pixels of the second pixel 892) for providing the narrow viewing angle. According to an embodiment, in order to implement high resolution, a gap between sub pixels composed of organic light emitting diodes may be narrow, so the display panel 800 providing high resolution may require deposition of the WOLED to provide the narrow viewing angle.

Referring to FIGS. 8B, 8C, and 8D, the display panel 800 may include a pixel layer 810, an encapsulation layer 820, a color filter layer 830, a compensation layer 840, a touch electrode 850, an organic insulation layer 860, and a transparent member 870.

Except for the pixel layer 810 in the display panel 800 of FIGS. 8B, 8C, and 8D, the electronic device or the display device may have the same or similar configuration as a display panel 600 of FIGS. 6A, 6B, and 6C.

According to an embodiment, the pixel layer 810 may include a semiconductor layer 801, a first electrode layer 803, an organic light emitting layer 807, a second electrode layer 809, and a pixel define layer 805. The semiconductor layer 801 may be a thin film transistor layer and may be electrically connected to an anode electrode of the first electrode layer 803 and a cathode electrode of the second electrode layer 809. The semiconductor layer 801 may be disposed on a substrate. The semiconductor layer 801 may emit light through an organic material of the organic light emitting layer 807 disposed between the first electrode layer 803 and the second electrode layer 809 by forming an electric field between the anode electrode and the cathode electrode. The organic light emitting layer 807 may be configured to emit white light.

Unlike the display panel 600 of FIGS. 6A, 6B, and 6C, the organic light emitting layer 807 may be a white organic light emitting diode (WOLED) that emits only white light. According to an embodiment, the pixel define layer 805 may be formed to surround a light emitting portion of a pixel. Portions corresponding to a portion classified by the pixel define layer 805 may be defined as pixels 891 and 892. In the pixel define layer 805, the anode electrode of the first electrode layer 803 may be disposed, a light emitting organic material of the organic light emitting layer 807 may be disposed, and the cathode electrode of the second electrode layer 809 may be disposed.

According to an embodiment, the encapsulation layer 820 may be formed to cover the anode electrode of the second electrode layer 809. According to an embodiment, the color filter layer 830 may be disposed on the encapsulation layer 820. The color filter layer 830 may have color filters of a color corresponding to a color designated for each pixel to transfer white light that is emitted from each of the pixels composing the pixel layer 810 and transmits through the color filter 831 of the color filter layer 830 to an outside.

For example, a pixel may be overlapped with one filter set composed of a red filter, a blue filter, and two green filters. The pixel may include four sub pixels, and each sub pixel may be disposed to overlap a filter of a designated color. A first sub pixel (e.g., the first sub pixel 310-1 of FIG. 3) may provide red light to the outside. Light emitted from the first sub pixel 310-1 may be white light, and the white light transferred from the first sub pixel 310-1 to the color filter 831 may be transferred to the outside of the display panel 800 by being filtered into red light. A second sub pixel (e.g., the second sub pixel 310-2 of FIG. 3) and a third sub pixel (e.g., the third sub pixel 310-3 of FIG. 3) may provide green light to the outside. Light emitted from the second sub pixel 310-2 and the third sub pixel 310-3 may be white light, and white light transferred from the second sub pixel 310-2 and the third sub pixel 310-3 to the color filter 831 may be transferred to the outside of the display panel 800 by being filtered into green light. A fourth sub pixel (e.g., the fourth sub pixel 310-4 of FIG. 3) may provide blue light to the outside. Light emitted from the fourth sub pixel 310-4 may be white light, and the white light transferred from the fourth sub pixel 310-4 to the color filter 831 may be transferred to the outside of the display panel 800 by being filtered into blue light. The above-described examples describe that the sub pixels 310-1, 310-2, 310-3, and 310-4 emit white light, but it is not limited thereto, the sub pixels 310-1, 310-2, 310-3, and 310-4 may emit one different color. For example, each of the sub pixels 310-1, 310-2, 310-3, and 310-4 emits blue light, and the emitted light may transfer light of the designated color filtered through the color filters to the outside.

According to an embodiment, the color filter layer 830 may have a plurality of filters including the color filter 831. A light blocking member 832 may be disposed between the plurality of filters. The light blocking member 832 may be disposed to overlap the pixel define layer 805 at least partially, when looking at the transparent member 870.

According to an embodiment, the compensation layer 840 may be disposed on the filter layer 830. The compensation layer 840 may have a thickness capable of securing a distance h2 between the light blocking member 861 adjacent to the transparent member 870 and the pixel layer 810 in order to secure a narrow viewing angle of the second pixel 892 of a second set (e.g., the second set 320 of FIG. 3).

According to an embodiment, the touch electrode 850 may include an insulation layer 851, a first conductive pattern 853, a second conductive pattern 854, and a protection layer 852. The first conductive pattern 853 may be interposed in the insulation layer 851, and the second conductive pattern 854 may be disposed on the insulation layer 851. The first conductive pattern 853 and the second conductive pattern 854 may at least partially overlap the light blocking member 861 when looking at the transparent member 870. The first conductive pattern 853 and the second conductive pattern 854 may not be visually recognized from the outside by the light blocking member 861.

According to an embodiment, the protection layer 852 may be formed to cover the second conductive pattern 854 of the touch electrode 850 to protect it. The protection layer 852 may be configured to prevent damage to the second conductive pattern 854. The protection layer 852 is an insulation layer and may include a single film or multiple films formed of a silicon composite. However, it is not limited thereto, and the protection layer 852 may be the single film or a multilayer film including an organic material.

According to an embodiment, the organic insulation layer 860 including the light blocking member 861 may be disposed on the touch electrode 850. The organic insulation layer 860 may include an organic material layer 862 surrounding the light blocking member 861. The organic material layer 862 may increase bonding strength with the transparent member 870 by flattening a layer including the light blocking member 861. According to an embodiment, the organic material layer 862 may be omitted in a case of flatly attaching the transparent member by increasing a thickness of an adhesive layer 865.

Referring to FIG. 8B, the organic insulation layer 860 may not include the light blocking member. According to an embodiment, an opening that transmits light emitted from the first pixel 891, which is a sub pixel providing a wide viewing angle, to the outside may be formed only in the color filter layer 830. For example, the color filter 831 of the color filter layer 830 may occupy the opening of the color filter layer 830. Referring to FIGS. 8C and 8D, openings 864-2 and 864-3 for transferring light emitted from the second pixel 892, which is a sub pixel that provides a narrow viewing angle, to the outside may be determined according to the number of micropixels (e.g., micropixels 320-1a, 320-1b, 320-1c, and 320-1d of FIG. 3) configured to divide light emitted from the second pixel 892.

According to an embodiment, a portion 892-1 and a portion 892-2 corresponding to the micropixels may be spaced apart from each other. In order to distinguish the micropixels, the light blocking member 861 may include a plurality of openings 864-2 and 864-3 on the second pixel 892. Widths d6-2 and d6-3 of the plurality of openings 864-2 and 864-3 may be configured such that the amount of light transferred through the second pixel 892 is substantially the same as the amount of light transferred through the first pixel 891.

According to an embodiment, the second pixel 892 may provide a viewing angle narrower than the viewing angle provided by the first pixel 891 due to the plurality of openings 864-2 and 864-3 while transferring the same or similar amount of light as the first pixel 891 to the outside.

Referring to FIGS. 8C and 8D, the light blocking member 861 may include the plurality of openings 864-2 and 864-3 that divide the second pixel 892.

According to an embodiment, the plurality of openings 864-2 and 864-3 of the light blocking member 861 may correspond to the micropixels (e.g., the micropixels 320-1a, 320-1b, 320-1c, and 320-1d of FIG. 3).

According to an embodiment, the openings 864-2 and 864-3 for transferring light emitted from the second pixel 892, which is a sub pixel that provides a narrow viewing angle, to the outside may be determined according to the number of micropixels 320-1a, 320-1b, 320-1c, and 320-1d configured to divide light emitted from the second pixel 892.

According to an embodiment, the portion 892-1 and the portion 892-2 corresponding to micropixels 8921 and 8922 may be spaced apart from each other. To classify the micropixels, the light blocking member 861 may include the plurality of openings 864-2 and 864-3 that overlap the second pixel 892. A sum of the widths d6-2 and d6-3 of the plurality of openings 864-2 and 864-3 may be equal to a width d6-1 of the opening 864-1. The plurality of openings 864-2 and 864-3 may be disposed in the portions 892-1 and 892-2 corresponding to the micropixels 8921 and 8922.

Referring to FIG. 8C, a viewing angle of a first micropixel 8921 corresponding to the portion 892-1 may be determined by a path of light emitted from a left side of the first micropixel 8921 of the second pixel 892 toward a right edge of a left opening 864-2 formed in the light blocking member 861, and a path of light emitted from a right side of the first micropixel 8921 of the second pixel 892 toward a left edge of the left opening 864-2 formed in the light blocking member 861. A viewing angle of a second micropixel 8922 may be determined by a right opening 864-3 formed in the light blocking member 861, similar to the viewing angle of the first micropixel 8921.

According to an embodiment, the color filter layer 830 may further include an additional light blocking member 8321 at a position corresponding to an additional pixel define portion 8051 that classifies the micropixels 8921 and 8922. The additional light blocking member 8321 may be integrally formed with the light blocking member 832 of the color filter layer 830. The light blocking member 832 and the additional light blocking member 8321 of the color filter layer 830 may prevent external light reflected from the pixel layer 810 from being viewed from the outside. According to an embodiment, at least one of the additional light blocking member 8321 and the additional pixel define portion 8051 may be omitted in a case where a narrow viewing angle of the second pixel 892 may be implemented. A case where both the additional light blocking member 8321 and the additional pixel define portion 8051 are omitted will be described with reference to FIG. 8D.

Referring to FIG. 8D, the viewing angle of the second micropixel corresponding to the portion 892-2 may be determined by a path of light emitted from a left side of the second pixel 892 toward a right edge of the right opening 892-2 formed in the light blocking member 861 and a path of light emitted from a right side of the second pixel 892 toward a left edge of the right opening 892-2 formed in the light blocking member 861.

According to an embodiment, a light emitting area that emits light to the color filter 831 through the second pixel 892 may be formed to be wider than a light emitting area of the first pixel 891. A width of the second pixel 892 may be wider than a width of the first pixel 891 in order to configure an amount of light transmitting from the second pixel 892 through the openings 864-2 and 864-3 of the light blocking member 861 to be equal to an amount of light transmitting from the first pixel 891 through the opening 864-1 of the light blocking member 861.

According to the above-described embodiment, a display device 300 and an electronic device 101 including the display panel 800 may deposit the WOLED to prevent color mixing that may occur during the deposition process of the organic light emitting diode. Due to the deposition of the WOLED, the display panel 800 may omit a polarizing layer as the color filter layer 830 is essentially required. According to the omission of the polarizing layer, a thickness of the encapsulation layer 820 may become thinner in order to prevent reflection of external light. In case that the encapsulation layer 820 is thick, a path (e.g., the path of light lp of FIG. 8B) of light reflected through the encapsulation layer 820 becomes long, so the light reflected to the outside may leak outside. The display panel 800 may shorten the path lp of reflected light by reducing the thickness of the encapsulation layer 820 and may minimize the amount of reflection of light leaking through the light blocking member 832. As the thickness of the encapsulation layer 820 becomes thinner, when the conductive patterns 853 and 854 are formed on the encapsulation layer 820, capacitance between the conductive patterns 853 and 854 and the pixel layer 810 may increase. Since the increased capacitance may delay a reaction time of the touch electrode 850, the touch electrode 850 may be stacked upper than the encapsulation layer 820 in order to reduce capacitance. The electronic device 101 and the display device 300 including the display panel 800 according to an embodiment include the compensation layer 840 for compensating for a viewing angle, and thus the touch electrode 850 may be disposed on the compensation layer 840. The touch electrode 850 disposed on the compensation layer 840 may secure a distance from the pixel layer 810.

The electronic device 101 and the display device 300 including the display panel 800 according to an embodiment may improve the performance of the touch electrode 850 and may prevent color mixing that may occur during the deposition process as the gap between pixels narrows according to the gap between anodes narrows, in order to secure a viewing angle, by using the WOLED.

FIG. 9A is an example illustrating a configuration in which a protection layer of a touch panel is included in a light blocking member in a portion in which a first pixel of a display device (e.g., WOLED display device) is disposed according to another embodiment, FIG. 9B is an example illustrating a configuration in which the protection layer of the touch panel is included in the light blocking member in a portion in which a second pixel of the display device (e.g., WOLED display device) is disposed according to another embodiment, and FIG. 9C illustrates a disposition in which the light blocking member of a color filter and a part of a pixel define portion are omitted while the protection layer of the touch panel is included in the light blocking member in a portion corresponding to the second pixel of the display device (e.g., WOLED display device) according to another embodiment.

Referring to FIGS. 9A, 9B, and 9C, a display panel 900 may include a pixel layer 910, an encapsulation layer 920, a color filter layer 930, a compensation layer 940, a touch electrode 950, an organic insulation layer 960, and a transparent member 970.

The configuration of the compensation layer 940, the touch electrode 950, and the organic insulation layer 960 in the display panel 900 of FIGS. 9A, 9B, and 9C may have a different configuration from that of a display panel 800 of FIGS. 8B, 8C, and 8D, and the remaining configuration may have a same or similar configuration as the display panel 800 of FIGS. 8B, 8C, and 8D.

According to an embodiment, the pixel layer 910 may include a semiconductor layer 901, a first electrode layer 903, an organic light emitting layer 907, a second electrode layer 909, and a pixel define portion 905, similarly to FIGS. 8B, 8C and 8D. The pixel define portion 905 may classify a light emitting portion and a non-light emitting portion in the pixel layer 910 and may partition a portion in which a pixel is positioned.

According to an embodiment, pixels disposed in the pixel define portion 905 may emit light through driving of the semiconductor layer 901. The semiconductor layer 901 may apply an electric field to the first electrode layer 903 and the second electrode layer 909. Organic materials included in the organic light emitting layer 907 may emit light by the first electrode layer 903 and the second electrode layer 909 on which the electric field is formed. The organic light emitting layer 907 may emit the same light from all pixels. The light emitted from the organic light emitting layer 907 may be emitted to an outside through the transparent member 970 in a designated color through the color filter 931 included in the color filter layer 930. The color filter 931 may be surrounded by the light blocking member 932, and one color filter may be disposed in a portion partitioned by the light blocking member 932.

According to an embodiment, in order to implement a narrow viewing angle of the second pixel 992, a compensation layer 940 for securing a distance between the light blocking member 961 disposed below the transparent member 970 and the pixel layer 910 may be disposed on the color filter layer 930.

According to an embodiment, the touch electrode 950 including an insulation layer 951 and the first conductive pattern 954 interposed in the insulation layer 951 and the second conductive pattern 953 disposed on the insulation layer 951 may be disposed on the compensation layer 940. A sufficient distance from the pixel layer 910 may be secured, as the touch electrode 950 is disposed on the compensation layer 940, and response speed and performance of the touch electrode 950 may be improved by lowering the capacitance value.

Compared to the display panel 800 of FIGS. 8B, 8C, and 8D, the touch electrode 950 may not include a protection layer (e.g., the protection layer 852 of FIG. 8B, the protection layer 852 of FIG. 8C, or the protection layer 852 of FIG. 8D) for protecting the second conductive pattern 953 printed on the insulation layer 951. The second conductive pattern 953 may prevent damage to the second conductive pattern 953 by protecting the second conductive pattern 953 through the light blocking member 961 formed of substantially the same insulation material as the protection layer.

According to an embodiment, the light blocking member 961 may cover the second conductive pattern 953. The light blocking member 961 may be an insulation layer formed of an organic material and may be formed in a color (e.g., black) with a high absorption rate of light. The light blocking member 961 may prevent the first conductive pattern 954 and the second conductive pattern 953 from being visible to the outside.

According to an embodiment, the organic insulation layer 960 may include the light blocking member 961 and an organic material layer 962 for flattening a surface of the light blocking member 961 facing the transparent member 970. The organic insulation layer 960 may be attached to the transparent member 970. For example, an adhesive layer 965 may be disposed between the organic insulation layer 960 and the transparent member 970. The organic material layer 962 of the organic insulation layer 960 may be omitted in case where the light blocking member 961 may be flattened by thickening the adhesive layer 965.

Referring to FIG. 9A, unlike FIG. 8B, the organic insulation layer 960 may include the light blocking member 961 and the organic material layer 962. In order to protect the pattern 953, the light blocking member 961 may be disposed on the pattern 953 in a portion corresponding to the first pixel 991. The touch electrode 950 includes patterns 953 and 954 formed on the insulation layer 951, and the pattern 953 formed on the top of the insulation layer 951 may not be covered by the protection layer (e.g., the protection layer 852 of FIG. 8B). In order to prevent damage to the pattern 953, the light blocking member 961 may protect the pattern 953 formed on the top of the insulation layer 951. The light blocking member 961 may include one opening 964-1 corresponding to the first pixel 991. A width of the light blocking member 961 may be formed enough to cover the patterns 953 and 954.

Referring to FIG. 9B, a viewing angle of a first micropixel 9921 corresponding to a portion 992-1 may be determined by a path of light emitted from a left side of the first micropixel 9921 of the second pixel 992 toward a right edge of a left opening 964-2 formed in the light blocking member 961, and a path of light emitted from a right side of the first micropixel 9921 of the second pixel 992 toward a left edge of the left opening 964-2 formed in the light blocking member 961. A viewing angle of a second micropixel 9922 corresponding to a portion 992-2 may be determined by a right opening 964-3 formed in the light blocking member 961, similar to the viewing angle of the first micropixel 9921.

According to an embodiment, the color filter layer 930 may further include an additional light blocking member 9321 at a position corresponding to an additional pixel define portion 9051 that classifies the micropixels 9921 and 9922. The additional light blocking member 9321 may be integrally formed with the light blocking member 932 of the color filter layer 930. The light blocking member 932 and the additional light blocking member 9321 of the color filter layer 930 may prevent external light reflected from the pixel layer 910 from being viewed from the outside. According to an embodiment, at least one of the additional light blocking member 9321 and the additional pixel define portion 9051 may be omitted in a case where a narrow viewing angle of the second pixel 992 may be implemented. A case where both the additional light blocking member 9321 and the additional pixel define portion 9051 are omitted will be described with reference to FIG. 9C.

Referring to FIG. 9C, the light blocking member 961 may include a plurality of openings 964-2 and 964-3 that divide the second pixel 992. The light blocking member 961 positioned on the first pixel 991 and the light blocking member 961 positioned on the second pixel 992 may be formed of the same light blocking member 961.

According to an embodiment, the plurality of openings 964-2 and 964-3 of the light blocking member 961 overlapping the second pixel 992 may correspond to micropixels (e.g., the micropixels 320-1a, 320-1b, 320-1c, and 320-1d of FIG. 3). The plurality of openings 964-2 and 964-3 may be formed in portions 992-1 and 992-2 corresponding to the micropixels.

According to an embodiment, only one opening 964-1 may be formed for transferring light emitted from the first pixel 991, which is a sub pixel that provides a wide viewing angle, to the outside. The openings 964-2 and 964-3 for transferring light emitted from the second pixel 992, which is a sub pixel providing a narrow viewing angle, to the outside may be determined according to the number of micropixels 320-1a, 320-1b, 320-1c, and 320-1d configured to divide light emitted from the second pixel 892.

According to an embodiment, the plurality of openings 964-2 and 964-3 of the light blocking member 961 overlapping the second pixel 992 may overlap the color filter 931 disposed on the second pixel 992. Light transferred through the plurality of openings 964-2 and 964-3 of the light blocking member 961 may be light transferred from the second pixel 992, and colors of the light transferred through the plurality of openings 964-2 and 964-3 may be the same.

According to an embodiment, a viewing angle provided from the first pixel 991 may be related to a width d7-1 of the first pixel 991 and a width d8-1 of the opening 964-1. The viewing angle of the first pixel 991 may be determined by an angle between a light path transferred from a left edge of the first pixel 991 to a right edge of the opening 964-1 of the light blocking member 961 and a light path transferred from a right edge of the first pixel 991 to a left edge of the opening 964-1 of the light blocking member 961.

According to an embodiment, a viewing angle provided from the second pixel 992 may be related to a width d7-2 of the second pixel 992 and widths d8-2 and d8-3 of the openings 964-2 and 964-3. The viewing angle of the second pixel 992 may be determined by an angle between a light path transferred from a left edge of the second pixel 992 to a right edge of the first opening 964-2 positioned in a portion of the light blocking member 961 overlapping the second pixel 992 and a light path transferred from a right edge of the second pixel 992 to a left edge of the first opening 964-2 positioned in a portion of the light blocking member 961 overlapping the second pixel 992. A viewing angle by the second opening 964-3 may also be determined by a relationship between the first opening 964-2 and the second pixel 992 described above.

According to the above-described embodiment, a display device 300 and an electronic device 101 including the display panel 900 may deposit a WOLED to prevent color mixing that may occur during a deposition process of an organic light emitting diode. With the deposition of the WOLED, a polarizing plate may be removed, and with the removal of the polarizing plate, a distance between the pixel and the light blocking member is reduced, there is a need to compensate for the viewing angle. The display device 300 or the electronic device 101 including the display panel 900 may dispose the compensation layer 940 in order to secure a narrow viewing angle and may secure a distance for securing the performance of the touch electrode 950 and preventing delay in reaction time by disposing the touch electrode 950 on the compensation layer 940.

According to an embodiment, an electrode pattern of the touch electrode 950 may be protected by using the light blocking member 961 disposed on the organic insulation layer 960 as the touch electrode 950 is disposed between the compensation layer 940 and the organic insulation layer 960. Since the process for forming the protection layer to protect the electrode pattern of the touch electrode 950 may be reduced, the manufacturing time of the display panel 900 may be reduced, and the production process may be simplified.

According to an embodiment, the electronic device 101 and the display panel 900 may improve the performance of the touch electrode 950, and may prevent color mixing that may occur during the deposition process as the gap between pixels is narrowed according to the gap between anodes narrows, in order to secure the viewing angle, by using WOLED, and may secure the performance of the touch electrode 950 by disposing the touch electrode 950 on the compensation layer 940. In addition, the patterns 953 and 954 of the touch electrode 950 may be protected by the light blocking member 961, and the manufacturing time may be shortened by removing the protection layer.

According to an embodiment, a display device (e.g., the display device 300 of FIG. 3) may comprise a display panel (e.g., the display panel 301 of FIG. 3) and a display driving integrated circuitry (DDI) (e.g., the display driving integrated circuitry 390 of FIG. 3) operatively coupled with the display panel, wherein the display panel may include a transparent member (e.g., the transparent member 670 of FIG. 6A), a pixel layer (e.g., the pixel layer 610 of FIG. 6A) including a first set (e.g., the first set 310 of FIG. 3) of a plurality of first pixels (e.g., the first pixels 311 and 312 of FIG. 3) and a second set (e.g., the second set 320 of FIG. 3) of a plurality of second pixels (e.g., the second pixels 321 and 322 of FIG. 3) providing a viewing angle narrower than a viewing angle provided through the plurality of first pixels, a touch electrode (e.g., the touch electrode 650 of FIG. 6A) disposed on the pixel layer and having a conductive pattern, an organic insulation layer (e.g., the organic insulation layer 660 of FIG. 6A) disposed between the transparent member and the touch panel, in contact with the transparent member, and including a light blocking member (e.g., the light blocking member 661 of FIG. 6A) having openings dividing each of sub pixels included in each of the plurality of second pixels, wherein the DDI provides a first mode of displaying an image based on driving both the first set and the second set and provides a second mode of displaying an image based on driving all of the second pixels in the second set and some of a plurality of sub pixels in each of the first pixels in the first set or displaying the image based on driving the second set of the first set and the second set.

According to an embodiment, the conductive pattern may overlap the light blocking member, when looking at the transparent member and may contact the light blocking member.

According to an embodiment, the display device may further comprise a protection layer (e.g., the protection layer 652 of FIG. 6A) disposed between the touch panel and the organic insulation layer and surrounding the conductive pattern.

According to an embodiment, a distance between the second pixels and the light blocking member may be longer than a width of each of the second pixels.

The display device according to an embodiment may further comprise an encapsulation layer (e.g., the encapsulation layer 620 of FIG. 6A) disposed on the pixel layer to encapsulate the pixel layer and a color filter layer (e.g., the color filter layer 630 of FIG. 6A) disposed on the encapsulation layer and including filters corresponding to each sub pixel of each of the first pixels and each of the second pixels.

The display device according to an embodiment may further comprise a compensation layer (e.g., the compensation layer 640 of FIG. 6A) disposed between the color filter layer and the touch panel and forming a viewing angle provided by the second pixels.

According to an embodiment, the color filter layer includes a second light blocking member (e.g., the light blocking member 632 of FIG. 6B) that includes openings corresponding to each of the sub pixels and is distinct from the light blocking member, which is a first light blocking member, wherein an area of an opening of the first light blocking member on the second pixel may be smaller than an area of an opening of the second light blocking member.

According to an embodiment, the amount of light provided by passing through the light blocking member from each of the sub pixels of each of the first pixels may be the same as the amount of light provided by passing through the light blocking member from each of the sub pixels of each of the second pixels.

According to an embodiment, a distance between sub pixels of each of the first pixels may be longer than a distance between sub pixels of each of the second pixels.

According to an embodiment, sub pixels of each of the first pixels and sub pixels of each of the second pixels are disposed in portions divided by pixel define layer (PDL) (e.g., the pixel define layer 605 of FIG. 6A), wherein a width of the PDL may be formed to be larger than a width of the light blocking member.

According to an embodiment, the pixel define layer may cover a part of sub pixels of each of the second pixels by the light blocking member, when looking at the transparent member.

According to an embodiment, an area of an anode electrode connected to each of the sub pixels included in each of the first pixels may be narrower than an area of the anode electrode connected to each of the sub pixels included in each of the second pixels.

According to an embodiment, a color of light emitted by the first pixels and the second pixels of the pixel layer may be the same.

An electronic device (e.g., the electronic device 101 of FIG. 1) according to an embodiment may comprise a transparent member (e.g., the transparent member 670 of FIG. 6A), a pixel layer (e.g., the pixel layer 610 of FIG. 6A) including a first set of a plurality of first pixels and a second set of a plurality of second pixels providing a viewing angle narrower than a viewing angle provided through the plurality of first pixels, a semiconductor layer (e.g., the semiconductor layer 601 of FIG. 6A) driving each of the first pixels and the second pixels and disposed below the pixel layer, a touch electrode (e.g., the touch electrode 650 of FIG. 6A) disposed on the pixel layer and having a conductive pattern, an organic insulation layer (e.g., the organic insulation layer 660 of FIG. 6A) disposed between the transparent member and the touch panel, in contact with the transparent member, and including a light blocking member having openings dividing each of sub pixels included in each of the plurality of second pixels, a protection layer (e.g., the protection layer 652 of FIG. 6A) disposed between the touch panel and the organic insulation layer and surrounding the conductive pattern, and a display driving integrated circuitry (DDI) (e.g., the display driving integrated circuitry 390 of FIG. 3) operatively coupled with the semiconductor layer, wherein the DDI provides a first mode of displaying an image based on driving both the first set and the second set and provides a second mode of displaying an image based on driving all of the second pixels in the second set and some of a plurality of sub pixels in each of the first pixels in the first set or displaying the image based on driving the second set of the first set and the second set.

The electronic device according to an embodiment may further comprise an encapsulation layer (e.g., the encapsulation layer 620 of FIG. 6A) disposed on the pixel layer to encapsulate the pixel layer and a color filter layer (e.g., the color filter layer 630 of FIG. 6A) disposed on the encapsulation layer and including filters corresponding to each sub pixel of each of the first pixels and each of the second pixels.

According to an embodiment, a thickness of the encapsulation layer may be smaller than a width of each of sub pixels of each of the second pixels.

According to an embodiment, the color filter layer may include a second light blocking member, which is distinguished from the light blocking member, which is a first light blocking member and including an opening corresponding to each of the sub pixels.

According to an embodiment, an area of an opening of the first light blocking member on the second pixel may be narrower than an area of an opening of the second light blocking member.

According to an embodiment, when looking at the transparent member, the conductive pattern may overlap the light blocking member and may contact the light blocking member.

According to an embodiment, a distance between sub pixels of each of the first pixels may be longer than a distance between sub pixels of each of the second pixels.

According to an embodiment, sub pixels of each of the first pixels and sub pixels of each of the second pixels are disposed in portions divided by a pixel define layer (PDL) (e.g., the pixel define layer 605 of FIG. 6A), and a width of the pixel define layer may be wider than a width of the light blocking member.

A display device (e.g., the display device 300 of FIG. 3) according to an embodiment may comprise a display panel (e.g., the display panel 700 of FIG. 7) and a display driving integrated circuitry (DDI) (e.g., the display driver IC 230 of FIG. 2) operatively coupled with the display panel, wherein the display panel may include a transparent member (e.g., the transparent member 770 of FIG. 7A), a pixel layer (e.g., the pixel layer 710 of FIG. 7A) including a first set of a plurality of first pixels and a second set of a plurality of second pixels providing a viewing angle narrower than a viewing angle provided through the plurality of first pixels, a touch electrode (e.g., the touch electrode 750 of FIG. 7A) including a conductive pattern disposed on one layer disposed between the transparent member and the pixel layer, and an organic insulation layer (e.g., the organic insulation layer 760 of FIG. 7A) in contact with one surface of the conductive pattern facing the transparent member and the transparent member, having openings that divide each of sub pixels included in each of the plurality of first pixels and the plurality of second pixels, and including a light blocking member (e.g., the light blocking member 761 of FIG. 7A) surrounding the conductive pattern exposed toward the transparent member, wherein the DDI may be configured to provide a first mode of displaying an image based on driving both the first set and the second set and provide a second mode of displaying an image based on driving all of the second pixels in the second set and some of a plurality of sub pixels in each of the first pixels in the first set or displaying the image based on driving the second set of the first set and the second set.

According to an embodiment, the touch electrode may include a second conductive pattern spaced apart from the first conductive pattern, which is the conductive pattern, and disposed on the one layer, and a conductive wire connecting the first conductive pattern and the second conductive pattern.

According to an embodiment, the touch electrode may include a first conductive pattern, which is the conductive pattern, and a second conductive pattern spaced apart in a direction toward the pixel layer and in contact with another surface facing one surface of the one layer, which is an insulation layer (e.g., the insulation layer 751 of FIG. 7A).

According to an embodiment, the one layer may be a compensation layer (e.g., the compensation layer 740 of FIG. 7A) on which the conductive pattern is printed to space the pixel layer and the light blocking member at a designated distance in order to secure a viewing angle provided by the second pixels.

According to an embodiment, openings corresponding to micropixels (e.g., the micropixels 7921 and 7922 of FIG. 7B) composing a sub pixel of the second pixel may be formed in the light blocking member, in a portion corresponding to a sub pixel of the second pixel.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A display device comprising:
a display panel; and
a display driving integrated circuitry (DDI) operatively coupled with the display panel;
wherein the display panel includes:
a transparent member;
a pixel layer including a first set of a plurality of first pixels and a second set of a plurality of second pixels providing a viewing angle narrower than a viewing angle provided through the plurality of first pixels;
a conductive pattern disposed on the pixel layer; and
an organic insulation layer disposed between the transparent member and the conductive pattern, in contact with the transparent member, and including a light blocking member having openings dividing each of sub-pixels included in each of the plurality of second pixels;
wherein the DDI provides a first mode of displaying an image based on driving both the first set and the second set and provides a second mode of displaying an image based on driving all of the plurality of second pixels in the second set and some of a plurality of sub pixels in each of the plurality of first pixels in the first set or displaying the image based on driving the second set of the first set and the second set.

2. The display device of claim 1, wherein the conductive pattern overlaps the light blocking member, when looking at the transparent member and the conductive pattern contacts the light blocking member.

3. The display device of claim 1, further comprising a protection layer disposed between the conductive pattern and the organic insulation layer and surrounding the conductive pattern.

4. The display device of claim 1, wherein a distance between the second pixels and the light blocking member is longer than a width of each sub pixel of the second pixels.

5. The display device of claim 1, further comprising:
an encapsulation layer disposed on the pixel layer to encapsulate the pixel layer; and
a color filter layer disposed on the encapsulation layer and including filters corresponding to each sub pixel of each of the first pixels and each of the second pixels.

6. The display device of claim 5, further comprising a compensation layer disposed between the color filter layer and the conductive pattern and forming the viewing angle provided by the second pixels.

7. The display device of claim 6, wherein the light blocking member is a first light blocking member and the color filter layer includes a second light blocking member distinct from the first light blocking member including openings corresponding to each of the sub pixels, and
wherein an area of each opening of the first light blocking member on the second pixels is smaller than an area of each opening of the second light blocking member.

8. The display device of claim 1, wherein a distance between sub pixels of each of the first pixels is longer than a distance between sub pixels of each of the second pixels.

9. The display device of claim 1, wherein sub pixels of each of the first pixels and sub pixels of each of the second pixels are disposed in portions divided by pixel define layer (PDL) and
wherein a width of the PDL is formed to be larger than a width of the light blocking member.

10. The display device of claim 1, wherein an area of an anode electrode connected to each of the sub pixels included in each of the first pixels is narrower than an area of the anode electrode connected to each of the subpixels included in each of the second pixels.

11. The display device of claim 1, wherein a color of light emitted by the first pixels and a color of light emitted by the second pixels of the pixel layer is the same.

12. An electronic device comprising:
a transparent member;
a pixel layer including a first set of a plurality of first pixels and a second set of a plurality of second pixels providing a viewing angle narrower than a viewing angle provided through the plurality of first pixels;
a semiconductor layer driving each of the first pixels and the second pixels and disposed below the pixel layer;
a conductive pattern disposed on the pixel layer; and
an organic insulation layer disposed between the transparent member and the conductive pattern, in contact with transparent member, and including a light blocking member having openings dividing each of subpixels included in each of the plurality of second pixels;
a protection layer disposed between the conductive pattern and the organic insulation layer and surrounding the conductive pattern and
a display driving integrated circuitry (DDI) operatively coupled with the semiconductor layer;
wherein the DDI provides a first mode of displaying an image based on driving both the first set and the second set and provides a second mode of displaying an image based on driving all of the plurality of second pixels in the second set and some of a plurality of sub pixels in each of the plurality of first pixels in the first set or displaying the image based on driving the second set of the first set and the second set.

13. The electronic device of claim 12, further comprising:
an encapsulation layer disposed on the pixel layer to encapsulate the pixel layer; and
a color filter layer disposed on the encapsulation layer and including filters corresponding to each sub pixel of each of the first pixels and each of the second pixels.

14. The electronic device of claim 13, wherein a thickness of the encapsulation layer is smaller than a width of each of sub pixels of the second pixels.

15. The electronic device of claim 12, wherein a distance between sub pixels of each of the first pixels is longer than a distance between sub pixels of each of the second pixels.
